# EUROPÄISCHE PATENTSCHRIFT

(11) **EP 3 280 052 B1**
(45) Veröffentlichungstag und Bekanntmachung des Hinweises auf die Patenterteilung: **30.03.2022**
(21) Anmeldenummer: 16182132.7
(22) Anmeldetag: 01.08.2016
(51) Int. Cl.: H03K 17/18, H02M 1/08, H02M 7/483

(54) **VERFAHREN UND VORRICHTUNG ZUR ANSTEUERUNG EINES SPANNUNGSGESTEUERTEN WIEDERABSCHALTBAREN LEISTUNGSHALBLEITERSCHALTERS**
METHOD AND DEVICE FOR DRIVING A VOLTAGE-CONTROLLED TURN-OFF POWER SEMICONDUCTOR SWITCH
PROCEDE ET DISPOSITIF DE COMMANDE D'UN CIRCUIT SEMI-CONDUCTEUR DE PUISSANCE COMMANDE PAR TENSION

(43) Veröffentlichungstag der Anmeldung: 07.02.2018
(73) Patentinhaber: GE Energy Power Conversion Technology Ltd, Rugby Warwickshire CV21 1BU (GB)
(72) Erfinder: Geske, Martin, 12277 Berlin (DE)
(74) Vertreter: Rüger Abel Patentanwälte PartGmbB

(56) Entgegenhaltungen:
- EP-A1- 2 768 140
- WO-A1-2015/024754
- DE-A1-102011 003 733
- US-A1- 2011 002 073
- YANG XIN ET AL: "Robust Stability Analysis of Active Voltage Control for High-power IGBT Switching by Kharitonov's Theorem", IEEE TRANSACTIONS ON POWER ELECTRONICS, INSTITUTE OF ELECTRICAL AND ELECTRONICS ENGINEERS, USA, Bd. 31, Nr. 3, 1. März 2016 (2016-03-01), Seiten 2584-2595, XP011590495, ISSN: 0885-8993, DOI: 10.1109/TPEL.2015.2439712 [gefunden am 2015-11-16]
- YANICK LOBSIGER ET AL: "Closed-loop IGBT gate drive featuring highly dynamic di/dt and dv/dt control", ENERGY CONVERSION CONGRESS AND EXPOSITION (ECCE), 2012 IEEE, IEEE, 15 September 2012 (2012-09-15), pages 4754-4761, XP032467005, DOI: 10.1109/ECCE.2012.6342173 ISBN: 978-1-4673-0802-1

## Beschreibung

Die vorliegende Erfindung betrifft ein Verfahren und eine Vorrichtung zur Ansteuerung eines spannungsgesteuerten, wiederabschaltbaren Leistungshalbleiterschalters. Insbesondere betrifft die Erfindung ein Verfahren und eine Vorrichtung zur Ansteuerung eines spannungsgesteuerten, wiederabschaltbaren Leistungshalbleiterschalters, um Verluste im Betrieb zu reduzieren und sein thermisches Verhalten zu verbessern.

Leistungshalbleiterbauelemente, wie z.B. IGBTs (Insulated Gate Bipolar Transistors), BIGTs (Bi-Mode Insulated Gate Transistors), MOSFETs (Metall Oxid Semiconductor Field Effect Transistors), IGCTs (Integrated Gate-Commutated Thyristors) und dgl., werden unter anderem zur Gleich- und Wechselrichtung von elektrischen Spannungen und Strömen verwendet. Hierzu geeignete Stromrichter weisen in der Regel mehrere Leistungshalbleiterschalter auf. Es sind Stromrichter in unterschiedlichen Topologien und für unterschiedliche Anwendungen zur Kopplung elektrischer Netze mit drehzahlvariablen Antrieben, zu Kompensationszwecken, zum Energieaustausch zwischen zwei elektrischen Netzen, etc. für unterschiedliche Leistungsniveaus bekannt.

Mit fortwährender Entwicklung von Leistungshalbleiterschaltern werden Stromrichter und neue Schaltungstopologien für immer höhere Leistungs- und/oder Spannungsbereiche gewünscht und entwickelt. Im Mittel- und Hochspannungsbereich werden bspw. Stromrichter eingesetzt, die eine Vielzahl von in Reihe und/oder parallel zueinander angeordneten Leistungshalbleiterschaltern oder daraus gebildeten Submodulen in Form von Halb-, Vollbrücken, oder dgl. aufweisen. Damit kann eine hohe Sperrfähigkeit und eine hohe Stromtragfähigkeit für die jeweilige Anwendung geschaffen werden, und die Spannungen können auf höchste Niveaus bis in Bereiche der Hochspannungsgleichstromübertragung (HGÜ) erhöht werden. Bei den klassischen 2- und 3-Level-Stromrichtern ist eine höhere Leistungsdichte von Interesse, die durch kompakte Bauweise in Verbindung mit verlustarmen Leistungshalbleitern durch geeignete Ansteuerung und einem optimalen Stromrichteraufbau und eine entsprechende Kühlung erreicht werden kann.

Halbleiterbauelemente erzeugen im Betrieb im Wesentlichen Leit- und Schaltverluste. In Abhängigkeit von der jeweiligen Anwendung ist die Verringerung von Halbleiterverlusten notwendig, um gegebenenfalls die Anforderungen an die thermische Auslegung verringern zu können bzw. höhere Anlageneffizienzen zu erreichen. In Anwendungsbereichen des Netzbetriebes, wie bspw. der Kompensationsanlagen oder z.B. sog. Static Synchronous Compensators (STATCOM), die im Pulsbetrieb betriebene Stromrichter sind, die ein dreiphasiges Spannungssystem mit variabler Spannungsamplitude und einer Phasenverschiebung von 90° gegenüber den Leitungsströmen generieren, der HGÜ oder von Pumpspeicherkraftwerken sind geringe Stromrichterverluste von äußerst hoher Bedeutung. Verluste werden hier häufig durch Kostenfaktoren bewertet, um die entsprechenden Anlagenverluste über einen veranschlagten Zeitraum (z.B. die Lebensdauer eines Stromrichters) im Anlagen- bzw. Stromrichterpreis zu berücksichtigen. Insofern ist es äußerst wichtig, Verluste auf ein Minimum zu reduzieren. Darüber hinaus ist es auch von Vorteil, die Verluste für selten auftretende Betriebspunkte mit hoher Last in unterschiedlichen Anwendungen auf ein Minimum zu reduzieren, um für diese Punkte keine generell überdimensionierte Auslegung der Kühlung vornehmen zu müssen.

Durch optimierte Pulsmuster und Systemauslegungen ist es möglich, Schaltverluste und Schaltfrequenz auf ein Minimum zu reduzieren. Einige bekannte Verfahren zielen darauf ab, die Schalttransienten beim Ein- und Ausschalten von Leistungshalbleiterschaltern zu beeinflussen, um die Schaltverluste zu reduzieren. Bspw. beschreibt Laurent Dulau, et al. "A New Gate Driver Integrated Circuit for IGBT Devices with Advanced Protections", IEEE Transactions on Power Electronics, Vol. 21, No. 1, Januar 2006, eine integrierte Schaltung einer Ansteuereinrichtung (eines Gatetreibers) für einen IGBT-Schalter, die eine zweistufige Ein- und Ausschaltung des IGBTs vorsieht, um die Rückstromspitze von der kommutierenden Diode beim Einschalten des IGBTs zu verringern bzw. die Abschaltüberspannung beim Abschalten des IGBTs zu reduzieren. Durch Erhöhung der Gatespannung auf eine Zwischenstufe, die geringfügig oberhalb der IGBT-Schwellenspannung liegt, für eine kurze Zeit vor dem endgültigen Einschalten des IGBTs, können der IGBT-Kollektorstrom und dessen Kollektorstromanstieg di_{c}/dt begrenzt und somit die Schaltverluste zusätzlich optimiert werden, unter Berücksichtigung des sicheren Arbeitsbereichs bzw. der Safe Operating Area (SOA) des Leistungshalbleiters. Ebenso wird durch Reduktion der Gatespannung auf eine geringfügig oberhalb der IGBT-Schwellenspannung befindliche Zwischenstufe für eine kurze Zeitdauer vor dem endgültigen Abschalten des IGBTs der Kollektorstromabfall begrenzt und somit die mögliche Abschaltüberspannung reduziert, was die Abschaltverluste während des Abschaltvorgangs auch reduzieren kann. In Anwendungen, in denen eine Vielzahl von Leistungshalbleiterschaltern mit hoher Frequenz, z.B. im kHz-Bereich geschaltet werden, kann dies die Gesamtverluste im Betrieb wesentlich reduzieren.

US 7 724 065 B2 beschreibt eine Gate-Treiberschaltung, die eine Entsättigung eines IGBTs im leitenden Zustand kurz vor dessen Abschalten ermöglicht. Infolgedessen können die Schalttransienten beim Abschalten verbessert, die Abschaltverluste bei einer Entsättigung mit optimierter Dauer vor dem Abschalten verringert und ggf. die Abschaltüberspannung reduziert werden.

Es ist auch vorgeschlagen worden, die Kollektorstromänderungsgeschwindigkeit di_{c}/dt und die Kollektor-Emitter-Spannungsänderungsgeschwindigkeit du_{CE}/dt eines IGBTs während eines Umschaltvorgangs zu steuern oder zu regeln, um durch Optimierung der Schalttransienten Schaltverluste zu minimieren.

Xin Yang et al.: "Robust Stability Analysis of Active Voltage Control for High-power IGBT Switching by Kharitonov's Theorem", IEEE TRANSACTIONS ON POWER ELECTRONICS; Bd. 31, Nr. 3, 1. März 2016, S. 2584-2595, beschreibt ein Verfahren zur Regelung der Kollektorspannung eines IGBTs während des Ausschaltens, um die transiente Kollektorspannung zu zwingen, einer vorgegebenen Sollschaltkurve zu folgen. Damit soll der IGBT während des Schaltvorgangs im sicheren Arbeitsbereich (SOA) betrieben werden, während Spannungs- bzw. Strombelastungen reduziert und elektromagnetische Störungen beschränkt werden sollen. Die Regelung der transienten Kollektorspannung kann basierend auf einer Gatespannung-Rückmeldung oder einer Rückmeldung bezüglich der Kollektorspannungssteilheit (dv/dt) erfolgen.

Yanick Lobsiger et al.: "Closed-Loop IGBT Gate Drive Featuring Highly Dynamic di/dt and dv/dt Control", ENERGY CONVERSION CONGRESS AND EXPOSITION (ECCE), IEEE, 15. September 2012, S. 4754-4761, beschreibt eine aktive Gate-Ansteuerung unter Verwendung eines geschlossenen Regelkreises zur Steuerung der Änderungsrate des Kollektorstroms di_{c}/dt und der Kollektor-Emitter-Spannung du_{CE}/dt beim Ein- und Ausschalten eines IGBTs. Es ist auch ein Regelungskonzept mit einem geschlossenen Regelkreis mit der Kollektor-Emitter-Spannung u_{CE} als die zur Rückführung für die Regelschleife dienende Messgröße und einem zeitlich variierenden Referenzprofil der Kollektor-Emitter-Spannung u_{CE} als Führungsgröße für den Abschaltvorgang offenbart.

EP 2 768 140 A1 beschreibt ein Verfahren zum Abschalten eines Halbleiterschalters, insbesondere IGBTs, bei dem nach Empfang eines Abschaltbefehls eine Ansteuerspannung an den Gate-Anschluss des IGBTs angelegt wird und die Ansteuerspannung geregelt wird, um die Kollektor-Emitter-Spannung mit einer variierenden Anstiegsrate bis zu einem vorbestimmten Spannungswert zu erhöhen, der einen stationären Wert der Kollektor-Emitter-Spannung überschreitet, wonach die Gate-Ansteuerspannung geregelt wird, um die Kollektor-Emitter-Spannung auf dem vorbestimmten Spannungswert zu halten.

Noch weiter können Schaltverluste durch Optimierung der Gatewiderstände R_{Gon} bzw. R_{Goff} unter Berücksichtigung der Grenzen des sicheren Arbeitsbereichs eines IGBTs und dessen kommutierender Diode minimiert werden. All diese Methoden sind auf die Optimierung der Schaltereignisse bzw. -übergänge gerichtet.

Darüber hinaus besteht die Möglichkeit, Leitverluste der Halbleiterbauelemente im leitenden Zustand zu verringern. Dies kann z.B. durch den physikalischen Aufbau des Bauelementes oder auch durch entsprechende Betriebsbedingungen erfolgen. Die Leitverluste eines IGBTs sind bei einem Betrieb mit verringerter Sperrschichttemperatur in der Regel geringer und können durch eine effiziente Kühlung reduziert werden. Letzteres erhöht aber den Platzbedarf für die Bauelemente und Kühlsysteme. Es können auch Leistungshalbleiterschalter mit geringer Durchlassspannung, sog. Low VCE(sat)-Transistoren eingesetzt werden, was aber die Kosten der Implementierung erhöhen oder andere Nachteile, wie bspw. erhöhte Schaltverluste, bedeuten kann. Es besteht der Wunsch, die Leitverluste generell oder in Abhängigkeit vom Arbeitspunkt des Stromrichters zu reduzieren, da diese gemeinsam mit den Schaltverlusten die Gesamtverluste von Leistungshalbleiterschaltern und daraus gebildeten Einrichtungen, z.B. Stromrichtern, ausmachen.

Ein weiterer wichtiger Aspekt im Zusammenhang mit der Anwendung von Leistungshalbleiterschaltern sind die benötigte Halbleiterfläche und Baugröße und die damit verbundenen Implementierungs- und Betriebskosten. Bspw. sind moderne Stromrichter, die aus IGBTs aufgebaut sind, unter dem Gesichtspunkt sicherer Betriebsbereichsgrenzen des IGBTs sowie der thermischen Grenzen der IGBTs hergestellt, die durch die transienten und statischen thermischen Widerstände, die Last, den elektrischen Arbeitspunkt und durch Kühlaspekte bestimmt sind. Für bestimmte kritische Situationen, wie bspw. kurzzeitige Überlast oder Stoßströme, könnten die thermischen Belastungsgrenzen der IGBTs überschritten werden. Eine sichere thermische Auslegung der IGBTs für diese seltenen Ereignisse würde zu einer kostspieligen Überdimensionierung der IGBTs, dessen Kühleinrichtung und des Stromrichters führen.

Aus der DE 10 2010 006 525 und der EP 2 747 260 A2 ist es bekannt, dass wiederabschaltbare Halbleiterschaltelemente, insbesondere IGBTs, kurzzeitig außerhalb der spezifizierten Parameter betrieben werden können, um eine Entsättigung zur Vermeidung und hohe Lastströme zu ermöglichen. Die DE 10 2010 006 525 B4 beschreibt eine Vorrichtung zur Ableitung von Stoßströmen oder transienten Überspannungen, bspw. infolge eines Blitzeinschlages mit einem widerabschaltbaren Halbleiterschaltelement, wobei die Einschaltung durch das statische Anlegen einer Gate-Emitter-Spannung außerhalb des für seine Gate-Emitter-Spannung für den Dauerbetrieb spezifizierten Bereichs erreicht wird. Üblicherweise werden IGBTs für den eingeschalteten Zustand bei 15 V betrieben, wobei nach der Spezifikation der Hersteller die Gate-Emitter-Spannung für den Dauerbetrieb typischerweise 20 V nicht übersteigen darf, weil ansonsten die isolierende Oxidschicht des Gates sehr stark an Lebensdauer einbüßt und infolgedessen deutlich früher als vorgesehen zerstört werden kann, was den IGBT in weiterer Konsequenz zerstört. Für die kurzzeitigen bzw. transienten Stoßströme infolge von Blitzeinschlägen wird eine erhöhte Gate-Emitter-Spannung von bspw. 30 V - 50 V vorgeschlagen. Das Schaltelement wird wieder abgeschaltet, nachdem der kurzzeitige bzw. transiente Stoßstrom abgeklungen ist.

Die EP 2 747 260 A2 beschreibt einen dreiphasigen Stromrichter mit IGBTs als Leistungshalbleiterschalter, wobei in dem Fall, dass Bedingungen erfasst werden, die einen Lastkurzschluss anzeigen, die Gate-Emitter-Spannung wenigstens eines Leistungshalbleiterschalters von einem Wert im normalen Betriebsmodus von bspw. 15 V auf einen höheren Wert erhöht wird. Der höhere Wert kann auch in einem Bereich zwischen etwa 30 V und etwa 70 V, außerhalb des zulässigen spezifizierten Bereichs liegen. Durch die daraus resultierende Erhöhung der Zweigströme in den fehlerfreien Zweigen kann eine Symmetrierung der Kurzschlussströme durch den Motor erreicht werden, und Pendeldrehmomente in dem Motor können vermieden werden.

DE 10 2011 003 733 A1 beschreibt ein Verfahren zur gepulsten Ansteuerung eines Transistors, der einen Ansteueranschluss und eine Laststrecke aufweist, wobei der Transistor beim Einschalten zunächst mit einem Ansteuerimpuls angesteuert wird, der einen ersten Ansteuerpegel aufweist, bevor ein weiterer Ansteuerimpuls angelegt wird, der einen höheren zweiten Ansteuerpegel aufweist, wobei die Spannung über der Laststrecke des Transistors ausgewertet und die gepulste Ansteuerung abgebrochen wird, wenn die Spannung über der Laststrecke einen vorgegebenen Schwellenwert übersteigt, was auf einen Kurzschluss der Last hinweist. Der erste Wert der Ansteuerspannung hat das Ziel, den Strom im Falle eines Kurzschlusses im Vergleich zur zweiten höheren Ansteuerspannunggering zu halten, um eine Zerstörung des Bauelements zu vermeiden.

Ausgehend hiervon ist es eine Aufgabe der vorliegenden Erfindung, ein Verfahren und eine Vorrichtung zur Ansteuerung eines spannungsgesteuerten, wiederabschaltbaren Leistungshalbleiterschalters zu schaffen, die dazu eingerichtet sind, Verluste des Leistungshalbleiterschalters im Betrieb zu reduzieren. Insbesondere ist es eine Aufgabe der vorliegenden Erfindung, Maßnahmen vorzuschlagen, um Leitverluste von Leistungshalbleiterschaltern während des leitenden bzw. eingeschalteten Zustands und somit Gesamtverluste von mit einer Vielzahl derartiger Leistungshalbleiterschalter aufgebauten Einrichtungen, insbesondere Stromrichtern, zu reduzieren, ohne die Kosten für die Implementierung und den Betrieb der Leistungshalbleiterschalter und der Einrichtungen, die Halbleiterfläche und Baugröße für die Halbleiterschalter, deren Kühleinrichtung, etc. zu vergrößern.

Diese Aufgabe wird durch ein Verfahren zur Ansteuerung eines spannungsgesteuerten wiederabschaltbaren Leistungshalbleiterschalters, eine Vorrichtung zur Ansteuerung eines spannungsgesteuerten wiederabschaltbaren Leistungshalbleiterschalters, einen Stromrichter und einen Datenträger mit den Merkmalen der unabhängigen Ansprüche gelöst. Besonders bevorzugte Ausführungsformen sind Gegenstand der abhängigen Ansprüche.

Gemäß einem Aspekt der Erfindung ist ein Verfahren zur Ansteuerung eines spannungsgesteuerten, wiederabschaltbaren Leistungshalbleiterschalters, der einen ersten und einen zweiten Anschluss sowie einen Steueranschluss aufweist und der im eingeschalteten Zustand zwischen dem ersten und dem zweiten Anschluss leitend ist, geschaffen. Das Verfahren enthält ein Anlegen einer ersten Ansteuerspannung, die einen ersten Wert aufweist, an den Steueranschluss, um den Leistungshalbleiterschalter einzuschalten. Das Verfahren enthält ferner ein Erfassen von Bedingungen, die den Fortgang eines Einschaltvorgangs des Leistungshalbleiterschalters kennzeichnen, durch Erfassen wenigstens eines Betriebsparameters an dem Leistungshalbleiterschalter, wozu wenigstens ein Spannungspotential an einem der Anschlüsse des Leistungshalbleiterschalters und/oder der Laststrom durch den Leistungshalbleiterschalter gehören. Das Verfahren enthält ferner ein Erfassen von Bedingungen, die dafür kennzeichnend sind, dass der Einschaltvorgang als abgeschlossen gilt. Das Verfahren enthält ferner ein Anlegen einer zweiten Ansteuerspannung, die einen zweiten Wert aufweist, der höher ist als der erste Wert, an den Steueranschluss, um den Leistungshalbleiterschalter im leitenden Zustand zu betreiben, sobald Bedingungen erfasst sind, die dafür kennzeichnend sind, dass der Einschaltvorgang als abgeschlossen gilt. Gemäß der Erfindung wird die an den Steueranschluss des Leistungshalbleiterschalters angelegte zweite Ansteuerspannung auf den zweiten Wert der zweiten Ansteuerspannung in einer geschlossenen Regelschleife geregelt, wobei die gemessene Durchlassspannung und/oder der gemessene Laststrom des Leistungshalbleiterschalters die zur Rückführung für die Regelschleife dienende Messgröße bildet.

Die Erfindung zielt darauf ab, Leitverluste von Leistungshalbleiterschaltern, insbesondere IGBTs, MOSFETs oder anderen eingangs erwähnten Leistungshalbleiterschaltern, im Betrieb auf der Basis der Ansteuerung zu verringern. Dies wird auf eine Weise erzielt, bei der der Schaltvorgang selbst nicht verändert wird. Erst nach erfolgtem, abgeschlossenem Einschalten bzw. Durchschalten des Leistungshalbleiterschalters wird dessen Ansteuerspannung, z.B. die Gatespannung bei einem IGBT, geeignet erhöht. Dies hat den Vorteil, dass die Kommutierung und das Schaltverhalten als solche unverändert bleiben. Darüber hinaus könnte ein direktes Ein- oder Ausschalten mit erhöhter Ansteuerspannung die Laststromtransienten negativ beeinflussen und zusätzlich höhere Schaltverluste bewirken. Außerdem würde ein direktes Einschalten mit höherer Ansteuerspannung die Schaltgeschwindigkeit beeinflussen, mit der Folge, dass die Abschaltüberspannung zunimmt, die Rückstromspitze einer dem Leistungshalbleiter zugeordneten Diode, die mit dem schaltenden Leistungshableiterschalter ein Kommutierungspaar bildet, sich erhöht und gegebenenfalls schnellere Anstiegszeiten der Halbleiter zusätzliche elektromagnetische Störungen verursachen oder parasitäre Effekte auftreten. Aus den zuerst benannten Gründen kann ggf. der sichere Arbeitsbereich der Halbleiter bzw. die Safe Operation Area (SOA) überschritten werden. Dies kann durch Einschalten mit einer ersten Ansteuerspannung im normalen Bereich von 10-15 Volt im Falle eines IGBTs oder eines MOSFETs vermieden werden. Des Weiteren können bei einem Einschaltvorgang ohne erhöhte Ansteuerspannung die bereits vorgesehenen Kurzschlussschutzmaßnahmen, die normallerweise direkt nach dem Einschaltvorgang aktiv werden, insbesondere die Überwachung des Kurzschluss-1, ohne zusätzliche Anpassung weiterverwendet werden. Der Typ "Kurzschluss-1" ist charakterisiert durch ein direktes Einschalten eines IGBTs auf einen Kurzschluss. Bei der entsprechenden Überwachung des Kurzschluss-1 wird direkt nach dem Einschalten überprüft, ob ein Kurzschluss existiert, der dementsprechend bereits vor dem Einschalten des Leistungshalbleiterschalters vorlag. Mit der Erfindung kann die Überwachung des Kurzschluss-1 direkt nach dem Einschalten auf die für die Standard-Ansteuerspannung entsprechenden Entsättigungsschwellen bestehen bleiben. Die Umschaltung auf das erhöhte, zweite positive Niveau der Ansteuerspannung erfolgt vorzugsweise erst nach abgeschlossener Überwachung des Kurzschluss-1.

Werden Bedingungen erfasst, die dafür kennzeichnend sind, dass der Einschaltvorgang als abgeschlossen gilt bzw. der Leistungshalbleiterschalter durchgeschaltet ist, kann der Erfindung entsprechend (gegebenenfalls nach abgeschlossener Überwachung des Kurzschluss-1) eine höhere zweite Ansteuerspannung an den Steueranschluss des Leistungshalbleiterschalters angelegt werden. Die erhöhte Ansteuerspannung setzt den Spannungssättigungsbereich höher, da der sog. "Pinch-off", d.h. das Abschnüren des leitfähigen Kanals unterhalb des Gates, erst bei höheren Strömen einsetzt und die Leitfähigkeit des Kanals erhöht wird. Damit werden für den Leistungshalbleiterschalter die Durchlassspannung und die Leitverluste im leitenden Betrieb verringert. Ferner wird dadurch auch die Sperrschichttemperatur des Leistungshalbleiterschalters im Vergleich zu einer geringeren Ansteuerspannung im leitenden Betrieb reduziert. Jeder Leistungshalbleiterschalter an sich und ein mit einer Vielzahl derartiger Leistungshalbleiterschalter aufgebauter Stromrichter können höhere Ströme führen oder die gleiche Überlast für eine längere Zeit übernehmen. Die Verbesserung des thermischen Verhaltens der Leistungshalbleiterschalter durch das erfindungsgemäße Verfahren hat auch geringere Kosten für das zugehörige Kühlsystem, einschließlich der Kühlkörper, Mittel zur Umwälzung eines Kühlfluids, etc., sowie eine Reduktion von Halbleiterkosten zur Folge. Es ist eine geringere Überdimensionierung der Leistungshalbleiterschalter erforderlich, um auch kurzzeitige Überlastbedingungen zu bewältigen.

Ohne auf die Werte gebunden sein zu wollen, wird geschätzt, dass eine Reduktion der Leitverluste eines Leistungshalbleiterschalters von bis zu 10% oder sogar mehr erreicht werden könnte. Dies könnte eine entsprechend höhere Leistung eines modularen Mehrpunktstromrichters im Wechselrichterbetrieb mit niedriger Schaltfrequenz im Bereich von 100 bis 150Hz bei gleicher thermischer Beanspruchung ergeben. Somit kann derselbe Stromrichter seine Nennausgangsleistung für Überlast- oder andere kritische Situationen erhöhen oder kann dieselben Überlastbedingungen über eine längere Zeitdauer hinweg bewältigen.

Der erhöhte Wert der zweiten Ansteuerspannung kann bspw. 15-20 V betragen. In bevorzugten Ausführungsformen kann er bei etwa 17-18 V liegen. Es sind auch Anwendungen vorgesehen, bei denen die zweite Ansteuerspannung höher ist als der für den Dauerbetrieb des Leistungshalbleiterschalters spezifizierte Bereich, insbesondere höher als 20 V für einen IGBT oder einen MOSFET. Z.B. kann sie bei 30 V oder mehr liegen. Dann werden die Leitverluste noch weiter verringert oder noch höhere Ströme durch Fehlerfälle im Netz oder Überlastanforderungen bewältigt.

Gemäß der Erfindung wird die an den Steueranschluss des Leistungshalbleiterschalters angelegte Spannung auf den zweiten Wert der zweiten Ansteuerspannung in einer geschlossenen Regelschleife geregelt. Dabei kann die gemessene Durchlassspannung an dem Leistungshalbleiterschalter und/oder der gemessene Strom durch diesen als die zur Rückführung für die Regelschleife dienende Messgröße herangezogen werden. Eine direkte Regelung kann die Durchlassspannung bei gegebenem Strom in Abhängigkeit von dessen Höhe und/oder der Kollektor-Emittersättigungsspannung gezielter anpassen. Die Regelung kann mit einer analogen Schaltung oder mit digitalen Mitteln, bspw. auf der Basis einer im Feld programmierbaren Gatter-Anordnung (FPGA), erfolgen.

Im Allgemeinen kann das Anlegen der ersten Ansteuerspannung als Reaktion auf den Empfang eines Steuersignals von einer übergeordneten Steuereinrichtung erfolgen. Das Steuersignal kann den Sollzustand des Leistungshalbleiterschalters repräsentieren, wie er durch die übergeordnete Steuereinrichtung vorgegeben wird. Die nachgeschaltete Ansteuereinrichtung, bspw. eine halbleiternahe Gate-Treiberschaltung, sorgt für die geeignete Ansteuerung des Leistungshalbleiterschalters beim Einschalten und im leitenden Zustand desselben entsprechend dem erfindungsgemäßen Verfahren.

Das Erfassen von Bedingungen, die den Fortgang eines Einschaltvorgangs des Leistungshalbleiterschalters kennzeichnen, umfasst ein Erfassen wenigstens eines Betriebsparameters an dem Leistungshalbleiterschalter, wobei zu den Betriebsparametern wenigstens ein Spannungspotential, bspw. das Potential am Kollektor (Drain), am Emitter (Source) oder am Gate-Anschluss im Falle eines IGBTs (MOSFETs) und/oder der Laststrom (Kollektorstrom, Drainstrom) durch den Leistungshalbleiterschalter gehören. Zusätzlich kann die Zeitdauer seit dem Anlegen der ersten Ansteuerspannung an den Steueranschluss erfasst werden.

In einer besonders vorteilhaften Ausführungsform eines beliebigen vorstehend erwähnten Verfahrens kann das Erfassen von Bedingungen, die dafür kennzeichnend sind, dass der Einschaltvorgang als abgeschlossen gilt, auf einer Zeiterfassung beruhen, indem der Ablauf einer Zeitdauer tₜₕ = t_{d(on)} + tᵣ + t_{add} seit dem Zeitpunkt des Anlegens der ersten Ansteuerspannung erfasst wird. Hierbei ist t_{d(on)} die Einschaltverzögerung, die die Verzögerung zwischen dem Einschalten an den Steueranschluss (hier insbesondere bei 10% der positiven Gatespannung definiert) bis zum Erreichen von 10% des Laststroms, z.B. des Kollektorstroms oder Drainstroms, während tᵣ die Anstiegszeit des Stromes durch den Leistungshalbleiterschalter ist. Diese Parameter sind für den jeweiligen Leistungshalbleiterschaltertyp in zugehörigen Datenblättern spezifiziert oder können für abweichende Verhältnisse hinsichtlich Spannung, Kommutierungskreisinduktivität, Sperrschichttemperatur für entsprechende Gatewiderstände und Ansteuerung durch Messung bestimmt werden. t_{add} ist eine zusätzliche Zeit, die die insbesondere vom Gatetreibertyp abhängige Zeitdauer zwischen dem Anlegen der Gatespannung bzw. Ansteuerspannung und dem Zeitpunkt des Erreichens von 10% des Kollektor- bzw. Drainstroms berücksichtigt und ferner berücksichtigen kann, dass während und kurz nach dem Einschalten Kurzschlussschutzüberwachungen und -maßnahmen vorgenommen werden können, die eine bestimmte Zeitdauer erfordern. Im Allgemeinen kann diese zusätzliche Zeitkonstante t_{add} im Bereich von 0-20 Mikrosekunden liegen. Vorzugsweise beträgt sie zwischen 5-15 Mikrosekunden. Bedarfsweise kann t_{add} auch mehr als 15 Mikrosekunden betragen. Somit wird eine Gesamtdauer tₜₕ seit dem Einschalten des Leistungshalbleiterschalters abgewartet, die vorzugweise wenigstens 25 Mikrosekunden oder sogar mehr als 30 oder 35 Mikrosekunden je nach Halbleiterbauelement und vorzugsweise so, dass die Überwachung des Kurzschluss-1 abgeschlossen ist, beträgt.

In einer vorteilhaften Alternative eines erfindungsgemäßen Verfahrens kann das Erfassen von Bedingungen, die dafür kennzeichnend sind, dass der Einschaltvorgang als abgeschlossen gilt, aufweisen, dass eine Kurzschlussüberwachung abgeschlossen ist, bei der überprüft wird, ob ein direktes Einschalten auf einen Kurzschluss vorliegt (Kurzschluss-1), wobei die zweite Ansteuerspannung angelegt wird, wenn festgestellt wird, dass kein Kurzschluss-1 vorliegt. Der Abschluss der Überwachung des Kurzschluss-1 selbst löst also das Umschalten der Ansteuerspannung auf das zweite Niveau aus. Ein Kurzschluss-1 kann bspw. durch Überwachung der Kollektor-Emitter-Spannung bzw. der Durchlassspannung, der Änderungsgeschwindigkeiten von Kollektorstrom und/oder Kollektor-Emitter-Spannung, der Ansteuerspannung und/oder des Stroms durch den Leistungshalbleiterschalter erfasst werden. Die Überwachung für den Typ Kurzschluss-1 dauert im Allgemeinen maximal 15 Mikrosekunden.

Gemäß der Erfindung weist das Erfassen von Bedingungen, die dafür kennzeichnend sind, dass der Einschaltvorgang als abgeschlossen gilt, auf, dass wenigstens eines der folgenden Kriterien erfüllt ist: Ein erstes Kriterium ist erfüllt, wenn erfasst wird, dass die Spannung an dem Steueranschluss (z.B. die Gatespannung) einen dritten Schwellenwert erreicht oder überschreitet, der höher ist als ein Wert des Miller-Plateaus der Ansteuerspannung. Beim Einschalten eines IGBTs oder MOSFETs steigt die Spannung am Gate zunächst bis zu einem Bereich an, der als "Miller-Plateau" bezeichnet wird, auf dem die Spannung für kurze Zeit annähernd konstant bleibt, obwohl Ladungsträger weiter zu der Steuerelektrode (dem Gate) fließen. Diese Ladungsträger werden in dieser Phase zur Umladung der Gate-Kollektor- bzw. Gate-Drain-Kapazität verwendet. Nach dem Durchlaufen des Miller-Plateaus steigt die Gatespannung auf ihren endgültigen Wert an. Das Durchlaufen und Verlassen des Miller-Plateaus der Gate-Spannung kann erfasst und als Kriterium zum Anlegen der zweiten Ansteuerspannung herangezogen werden.

Der dritte Schwellenwert kann mindestens 90% des Wertes der ersten Ansteuerspannung betragen. Vorzugsweise beträgt er mindestens 95% des Wertes der ersten Ansteuerspannung.

Als ein weiteres Kriterium kann das Erfassen von Bedingungen, die dafür kennzeichnend sind, dass der Einschaltvorgang als abgeschlossen gilt, aufweisen, dass erfasst wird, dass die Durchlassspannung, bspw. die Kollektor-Emitter-Spannung (Drain-Source-Spannung) eines IGBTs (MOSFETs), zwischen dem ersten und dem zweiten Anschluss einen zweiten Schwellenwert erreicht oder unterschreitet, der dafür kennzeichnend ist, dass der Leistungshalbleiterschalter eingeschaltet ist. Nach dem Einschalten sinkt die Kollektor-Emitter-Spannung auf einen für den Strom und die Temperatur entsprechenden endgültigen Wert der Durchlassspannung bzw. auf U_{CEsat} ab. Ein geeigneter zweiter Schwellenwert detektiert, dass die Kollektor-Emitter-Spannung auf einen typischen Wert für den Leitendbetrieb abgesunken ist und der Leistungshalbleiterschalter vollständig eingeschaltet ist. Vorteilhafter Weise liegt dieser Schwellenwert etwas oberhalb der maximal zu erwartenden Durchlassspannung, die durch Messung für unterschiedliche Ströme und Temperaturen ermittelt werden kann und ggf. unter Berücksichtigung der Streuung der Halbleiterbauelemente mit einem Sicherheitsaufschlag festgelegt wird.

Der zweite Schwellenwert für die Durchlassspannung kann bspw. im Bereich von 10 V bis 0,5 V liegen. Vorzugsweise ist er kleiner als 5 V.

Als ein noch weiteres Kriterium kann das Erfassen von Bedingungen, die dafür kennzeichnend sind, dass der Einschaltvorgang als abgeschlossen gilt, aufweisen, dass erfasst wird, dass der zwischen dem ersten und dem zweiten Anschluss fließende Strom, bspw. Kollektor- oder Drainstrom, eine Stromspitze durchlaufen hat, die einer beim Einschalten des Halbleiterschalters auftretenden Rückstromspitze entspricht, die von einer Diode durch den Reverse Recovery Effekt auf den Leistungshalbleiterschalter kommutiert. Vorzugsweise wird überprüft, dass nach Durchlaufen der Rückstromspitze der Strom einen ersten Schwellenwert wieder unterschritten hat, bei dem die Änderungsgeschwindigkeit dI_{c/}dt des Stroms durch den Leistungshalbleiterschalter betragsmäßig weniger als 20 %, vorzugsweise weniger als 10 % des Stromanstiegs von 10 % bis 90 % des Stroms I_{c} beim Einschalten des Leistungshalbleiterschalters beträgt.. Ist diese Bedingungen erfüllt, kann der Leistungshalbleiterschalter als eingeschaltet angenommen und die höhere, zweite Ansteuerspannung angewandt werden.

In einer Weiterbildung eines beliebigen vorstehend erwähnten Verfahrens kann nach der Erfassung von Bedingungen, die dafür kennzeichnend sind, dass der Einschaltvorgang als abgeschlossen gilt, zunächst noch überprüft werden, ob Überlastbedingungen vorliegen, wobei die zweite Ansteuerspannung nur dann angelegt wird, falls festgestellt wird, dass Überlastbedingungen vorliegen. Die Überprüfung auf Überlastbedingungen kann bspw. anhand der Durchlassspannung und/oder des Kollektorstroms erfolgen. Überlastbedingungen können bspw. vorliegen, wenn die Durchlassspannung und/oder der Kollektorstrom einen vorgegebenen vierten Schwellenwert überschreitet bzw. überschreiten, der größer als der zweite Schwellenwert bzw. der Nennstrom des Halbeiterbauelements ist. Die Überlastbedingung für den Kollektorstrom liegt bspw. im Bereich des Nennstroms des Leistungshalbleiterschalters, kann aber je nach Anwendung auch bis zum zweifachen Wert des Nennstroms betragen.

In einem weiteren Aspekt der Erfindung ist eine Vorrichtung zur Ansteuerung eines spannungsgesteuerten, wiederabschaltbaren Leistungshalbleiterschalters geschaffen, der einen ersten und einen zweiten Anschluss sowie einen Steueranschluss aufweist, insbesondere eines IGBTs oder eines MOSFETs, wobei der Leistungshalbleiterschalter im eingeschalteten Zustand zwischen dem ersten und dem zweiten Anschluss leitend ist. Die Vorrichtung ist zur Durchführung des Verfahrens, wie vorstehend beschrieben, eingerichtet. Hierzu weist die Vorrichtung eine Erfassungseinrichtung zur Erfassung wenigstens eines Betriebsparameters an dem Leistungshalbleiterschalter, wozu wenigstens ein Spannungspotential an einem der Anschlüsse des Leistungshalbleiterschalters und/oder der Laststrom durch den Leistungshalbleiterschalter gehören, und eine Regeleinrichtung zur Regelung der an die Steuerelektrode des Leistungshalbleiterschalters angelegten Spannung auf den zweiten Wert der zweiten Ansteuerspannung in einer geschlossenen Regelschleife unter Verwendung der gemessenen Durchlassspannung und/oder des gemessenen Laststroms des Leistungshalbleiterschalters als die zur Rückführung für die Regelschleife dienende Messgröße bzw. Regelgröße, während der Leistungshalbleiterschalter leitend (vollständig eingeschaltet) ist.

Die Vorrichtung, die bspw. als Gate-Treiber bezeichnet werden kann, ist vorzugsweise in einer Schaltung in der unmittelbaren Nähe des Leistungshalbleiterschalters angeordnet. Sie ermöglicht es, den oder die zugehörigen Leistungshalbleiterschalter gemäß dem erfindungsgemäßen Verfahren anzusteuern, um dessen Leitverluste im Betrieb zu reduzieren. Dies kann die erfindungsgemäße Vorrichtung von sich aus realisieren, ohne dass in die übergeordnete Steuerung eingegriffen werden muss.

Insbesondere kann die erfindungsgemäße Ansteuerungsvorrichtung eine Treibereinrichtung aufweisen, die eingerichtet ist, um EIN- und AUS-Steuerbefehle von einer übergeordneten Steuerung zu empfangen, die den Sollzustand des Leistungshalbleiterschalters kennzeichnen, und Ansteuerspannungen für den Leistungshalbleiterschalter entsprechend dem erfindungsgemäßen Verfahren zu erzeugen. Die Vorrichtung kann ferner eine Zeitkontrolleinrichtung zur Erfassung der Zeitdauer seit dem Anlegen der ersten Ansteuerspannung an den Steueranschluss aufweisen. Ferner kann die Ansteuerungsvorrichtung eine Auswerteeinrichtung enthalten, die die erfassten Parameter oder Zeitwerte mit Schwellenwerten vergleicht und in Abhängigkeit davon die Treiberschaltung anweist, die geeignete Ansteuerspannung zu erzeugen und an das Gate des Leistungshalbleiters zu legen.

Im Übrigen wird hinsichtlich der Ausführungsformen und Weiterbildungen der erfindungsgemäßen Ansteuerungsvorrichtung und deren Vorteile auf die obigen Ausführungen zu dem erfindungsgemäßen Verfahren verwiesen, die hier analog gelten.

In einem noch weiteren Aspekt der Erfindung ist ein Stromrichter zur Umwandlung von Gleichstrom in Wechselstrom und umgekehrt mit einer Vielzahl von Leistungshalbleiterschaltern geschaffen, wobei den Leistungshalbleiterschaltern jeweils einzeln oder gruppenweise eine Vorrichtung, wie vorstehend beschrieben, zugeordnet ist. Dem Stromrichter kommen die bereits im Zusammenhang mit dem erfindungsgemäßen Ansteuerungsverfahren und der erfindungsgemäßen Ansteuervorrichtung vorstehend erwähnten Vorteile zugute.

In einem noch weiteren Aspekt ist ein Datenträger geschaffen, der computerlesbare Anweisungen zum Ausführen des vorstehend beschriebenen Verfahrens aufweist. Die Erfindung kann somit in Form von computerlesbaren Anweisungen zur Steuerung eines programmierbaren Computers oder einer sonstigen programmierbaren Rechenvorrichtung in einer derartigen Weise verkörpert sein, dass die Anweisungen, wenn sie durch den Computer bzw. die Rechenvorrichtungen ausgeführt werden, das vorstehend erläuterte erfindungsgemäße Ansteuerungsverfahren durchführen. Derartige Anweisungen können in Form eines Computerprogrammproduktes mit einem computerlesbaren Medium, das die Anweisungen speichert, verwirklicht sein. Insbesondere können die Anweisungen in eine FPGA oder einen Mikrocontroller in einer Ansteuerungseinrichtung (z.B. einen Gatetreiber) geladen werden, die dazu bestimmt ist, die Ansteuerungsspannung für den Leistungshalbleiterschalter zu liefern.

Weitere vorteilhafte Einzelheiten von Ausführungsformen der Erfindung ergeben sich aus Unteransprüchen, der Zeichnung sowie der zugehörigen Beschreibung. Die Erfindung ist nachstehend anhand einer Zeichnung näher beschrieben, die beispielhafte, keinesfalls beschränkende Ausführungsformen der Erfindung zeigt, wobei gleiche Bezugszeichen in allen Figuren verwendet werden, um gleiche Elemente zu bezeichnen. Es zeigen:
Fig. 1 ein beispielhaftes System mit einem aus mehreren Submodulen aufgebauten modularen Mehrpunktstromrichter zur Kopplung eines elektrischen Energieversorgungsnetzes, einer elektrischen Maschine oder einer anderen Wechselspannungsquelle mit einem anderen Netz oder einer Last zur Verdeutlichung einer beispielhaften Anwendung der Erfindung, in Form eines vereinfachten Blockdiagramms;
Fig. 2 einen vereinfachten Schaltplan eines Stromrichter-Submoduls mit einer Halbbrückentopologie, das in dem modularen Mehrpunktstromrichter nach Fig. 1 gemäß der Erfindung verwendet werden kann, mit zugehörigen Ansteuereinrichtungen;
Fig. 3 einen Leistungshalbleiterschalter des Submoduls nach Fig. 2 mit zugehöriger Ansteuereinrichtung in größerer Detailtiefe, in Form eines vereinfachten Blockdiagramms;
Fig. 4 einen Schaltplan einer Treibereinrichtung zur Verwendung in der Ansteuereinheit nach Fig. 3, in vereinfachter Darstellung;
Fig. 5 eine grafische Darstellung von Spannungs- und Stromverläufen für einen Leistungshalbleiterschalter zur Definition von Schaltzeiten;
Fig. 6 ein Flussdiagramm eines erfindungsgemäßen Verfahrens zur Ansteuerung eines Leistungshalbleiterschalters, in vereinfachter Darstellung;
Fig. 7 eine Ausgangscharakteristik eines Leistungshalbleiterschalters in Form eines IGBTs für verschiedene Ansteuerspannungen, in vereinfachter Darstellung; und
Figuren 8a und 8b Schaltpläne einer Regeleinrichtung zur Verwendung bei der erfindungsgemäßen Ansteuereinrichtung gemäß einer Ausführungsformen der Erfindung, in vereinfachter Darstellung.

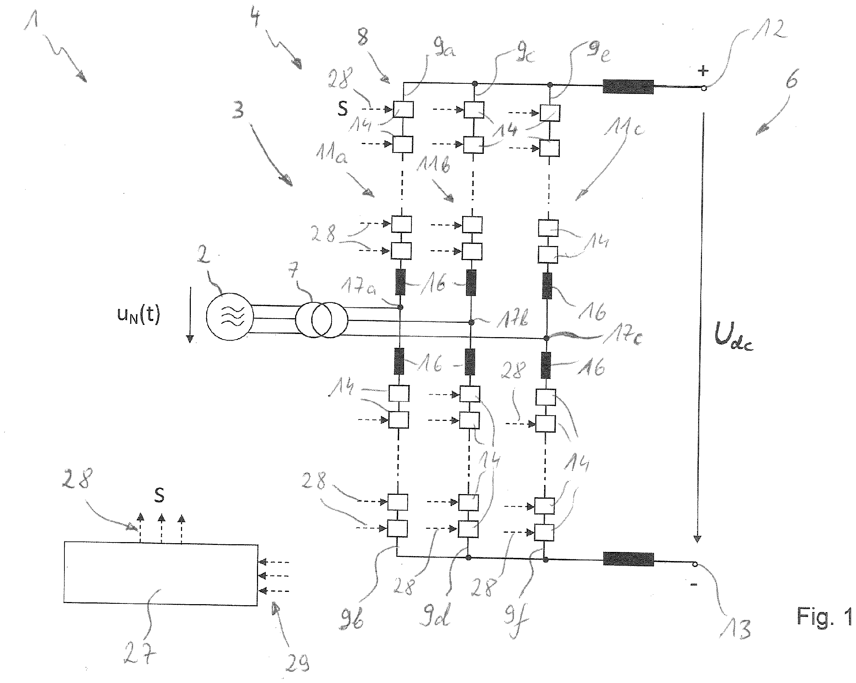

In Fig. 1 ist in einer vereinfachten Darstellung ein System 1 veranschaulicht, das sich für ein Hochspannungsgleichstrom-Verteilungssystem zur elektrischen Energieübertragung bei hoher Gleichspannung oder für viele andere Anwendungen eignet. Das System 1 umfasst eine hier bspw. dreiphasige Wechselspannungsquelle 2, die z.B. ein elektrisches Energieversorgungsnetz, eine elektrische Wechselstrom(AC)-Maschine, ein AC-Generator, eine Windkraftanlage oder dgl. sein kann. An die Wechselspannungsquelle 2 ist mit seiner Wechselspannungsseite 3 ein elektrischer Umrichter 4 angeschlossen, dessen Gleichspannungsseite 6 über eine hier nicht näher dargestellte Gleichstromübertragungseinrichtung mit einem anderen elektrischen Energieversorgungsnetz verbunden sein kann. Der Anschluss des Umrichters 4 an die Wechselspannungsquelle 2 kann optional über einen Transformator 7 erfolgen.

Der Umrichter 4 weist wenigstens einen ersten Stromrichter 8 auf, der hier ein Gleichrichter sein kann, um eine Wechselspannung u_{N}(t) der Wechselspannungsseite 2 in eine ausgangsseitige Gleichspannung U_{dc} zu wandeln. Optional könnte der Umrichter 4 einen hier nicht dargestellten weiteren Stromrichter aufweisen, der die Spannung U_{dc} in eine für ein anderes Netz oder einen elektrischen Antrieb passende Wechselspannung wandelt oder dem ersten Stromrichter 8 parallel geschaltet ist. Es versteht sich, dass sich die Funktionen der Stromrichter umkehren, wenn der Energiefluss umgekehrt zu dem Energieversorgungsnetz oder der Spannungssenke 2 hin erfolgt.

Wie aus Fig. 1 ersichtlich, weist der Stromrichter 8 hier sechs Stromrichterzweige 9a-9f auf, von denen jeweils zwei, ein oberer und ein unterer 9a, 9b bzw. 9c, 9d bzw. 9e, 9f einen jeweiligen Phasenzweig 11a, 11b bzw. 11c bilden. Jeder Phasenzweig 11a, 11b, 11c erstreckt sich zwischen einer positiven Stromschiene bzw. einem positiven Gleichspannungsanschluss ("+") 12 des Stromrichters 8 und einer negativen Stromschiene bzw. einem negativen Gleichspannungsanschluss ("- ") 13. Es versteht sich, dass der Stromrichter 8 je nach gewünschter Anzahl von Phasen auch nur einen Phasenzweig 11, zwei Phasenzweige oder auch mehr als drei Phasenzweige aufweisen kann.

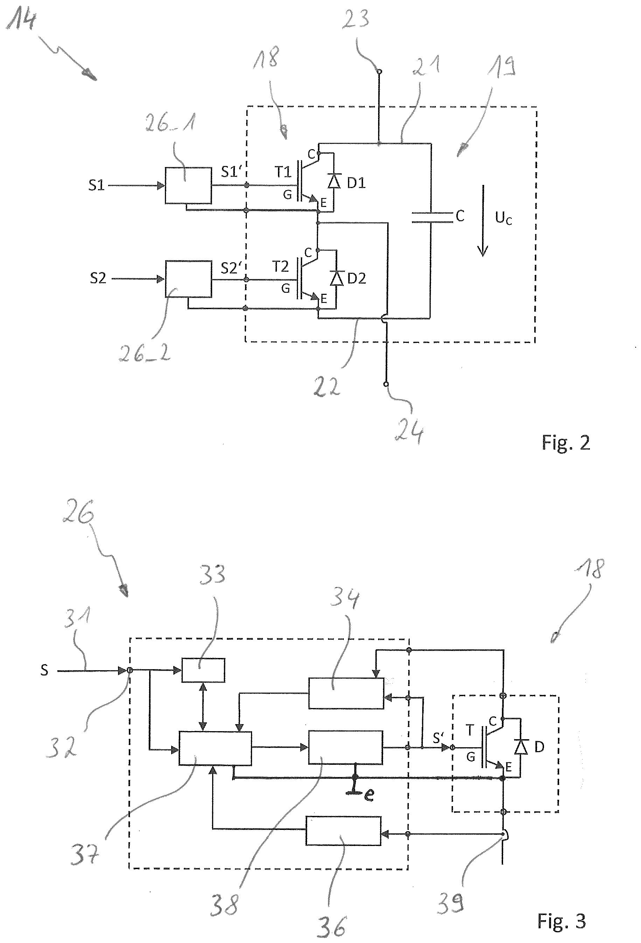

Wie ferner aus Fig. 1 ersichtlich, weist jeder Stromrichterzweig 9a-f hier eine Reihenschaltung aus mehreren in Reihe geschalteten Stromrichter-Submodulen 14 auf. Die steuerbare Gleichspannung U_{dc} an den Gleichspannungsanschlüssen 12, 13 des Stromrichters 8 kann über die Schaltzustände der einzelnen Stromrichter-Submodule 14 dynamisch verändert werden. Die Anzahl der Stromrichter-Submodule 14 bestimmt dabei die verfügbare Anzahl von Stromrichter-Schaltzuständen, die eine feine Spannungsstufung und eine Spannungsform hoher Güte sowie hohe Spannungsniveaus bis auf Hochspannungs-Gleichspannungs-Über-tragungs(HGÜ)-Niveaus ermöglichen. Bei dem Stromrichter 8 handelt es sich um einen modularen Multi-Level- oder Mehrpunktstromrichter. Ein beispielhaftes Submodul 14 ist nachstehend im Zusammenhang mit Fig. 2 näher erläutert.

In den Stromrichterzweigen 9a-f können jeweils kreisstrombegrenzende Induktivitäten 16 vorgesehen sein, die eine Entkopplung der Stromrichterzweige voneinander unterstützen. An dem Verbindungspunkt zwischen den zugehörigen Stromrichterzweigen 9a, 9b bzw. 9c, 9d bzw. 9e, 9f sind die jeweiligen Wechselspannungsanschlüsse 17a, 17b, 17c des Stromrichters 8 herausgeführt, die mit der Wechselspannungsquelle 2 verbunden sind. Die gleichspannungsseitigen Anschlüsse der ersten obersten Submodule 14 des Stromrichters 8 sind miteinander und mit der positiven Stromschiene 12 verbunden. Ähnlich sind die gleichspannungsseitigen Anschlüsse der letzten, untersten Submodule 14 miteinander und mit der negativen Stromschiene 13 verbunden. Zwischen den Stromschienen 12, 13 liegt die Gleichspannung U_{dc} an, die eine Hochspannung von bspw. über 100 kV sein kann.

Fig. 2 zeigt in Form eines vereinfachten Schaltplans eine Topologie eines Halbbrücken-Submoduls 14, wie es in dem modularen Mehrpunktstromrichter 8 nach Fig. 1 verwendet werden kann. Es sollte beachtet werden, dass anstelle des Halbbrücken-Submoduls 14 auch andere in der Technik bekannte Submodule auf der Basis von Voll- oder H-Brücken, gemischten Zellen, asymmetrischen Zellen und dgl. verwendet werden können.

Bezugnehmend auf Fig. 2 weist das Submodul 14 eine Halbbrückenschaltung 18 und einen zu der Brückenschaltung 18 parallel geschalteten Kondensator C, 19 auf. Die Halbbrückenschaltung 18 ist durch eine Reihenschaltung aus einem ersten Leistungshalbleiterschalter T1, dem eine antiparallele bzw. gegensinnig parallel geschaltete Freilaufdiode D1 zugeordnet ist, und einem zweiten Leistungshalbleiterschalter T2 gebildet, dem eine antiparallele Freilaufdiode D2 zugeordnet ist. Die Leistungshalbleiterschalter T1, T2 sind in Reihe zwischen einem ersten und einem zweiten Gleichspannungsknoten bzw. Polanschluss 21, 22 geschaltet, wobei die Freilaufdioden D1 und D2 in Durchflussrichtung von dem zweiten, in Fig. 2 unteren Polanschluss 22 zu dem ersten, oberen Polanschluss 21 des Submoduls 14 ausgerichtet sind. Ferner ist jede Diode D1, D2 mit ihrer Anode mit dem Emitter des jeweiligen Leistungshalbleiterschalters T1 bzw. T2, der hier als ein IGBT ausgebildet ist, verbunden, während die Kathode mit dem jeweiligen Kollektor des zugehörigen IGBTs T1 bzw. T2 verbunden ist.

Der Kondensator C, 19 als Energiespeicher des Submoduls 14 ist zwischen den Polanschlüssen 21, 22 angeschlossen. Er kann ein unipolarer Kondensator sein, der als ein Gleichspannungszwischenkreiskondensator des Submoduls 14 dient. In anderen Stromrichtertopologien kann der Kondensator C auch weggelassen werden.

Die Leistungshalbleiterschalter T1, T2 sind ansteuerbare Schalter, die hier vorzugsweise durch IGBTs gebildet sind. Prinzipiell können aber auch andere spannungsgesteuerte abschaltbare Transistoren, wie bspw. Feldeffekttransistoren, insbesondere MOSFETs, oder Gate-Turn-Off-Thyristoren (GTOs) und andere vergleichbare elektronische Bauelemente eingesetzt werden, bei denen die Größe der Ansteuerspannung die resultierende Durchlassspannung des Leistungshalbleiterschalters im leitenden Betrieb beeinflussen kann. Ein Fachmann wird Ausführungen, die bestimmte Anschlüsse eines IGBTs betreffen, ohne weiteres auf entsprechende Anschlüsse anderer Leistungshalbleiterarten übertragen können.

Der erste Polanschluss 21 bildet einen ersten Submodulanschluss 23, während der Verbindungspunkt zwischen den Leistungshalbleiterschaltern T1, T2 bzw. den Freilaufdioden D1, D2 einen zweiten Submodulanschluss 24 bildet. Über die Submodulanschlüsse 23, 24 können die Submodule 14 in dem Stromrichter 8 nach Fig. 1 in Reihe miteinander verbunden werden.

Je nach dem Schaltzustand der Leistungshalbleiterschalter T1, T2 kann wahlweise ermöglicht werden, dass die Spannung zwischen dem ersten und dem zweiten Submodulanschluss 23, 24 null beträgt oder gleich der Spannung U_{c} des Speicherkondensators C, 19 ist und dass der Speicherkondensator C, 19 Energie abgeben oder aufnehmen kann. Sind beide Schalter T1, T2 ausgeschaltet, kann der Kondensator C, 19 keine Energie abgeben, was in einem äußeren Fehlerfall, bspw. einem Lastkurzschluss, vorteilhaft genutzt werden kann.

Wie ferner aus Fig. 2 ersichtlich, ist jedem Leistungshalbleiterschalter T1, T2 eine Ansteuereinheit 26 1 bzw. 26_2 zugeordnet, die dazu dient, eine geeignete Ansteuerspannung an die Steuerelektrode, den Gate, des jeweiligen Leistungshalbleiterschalters T1, T2 anzulegen, um diesen ein- bzw. auszuschalten. Im eingeschalteten Zustand sind die Leistungshalbleiterschalter T1, T2 leitend, so dass ein Strom zwischen dem Kollektor C und dem Emitter E eines jeweiligen IGBTs T1 bzw. T2 fließen kann. Die Ansteuereinheiten 26_1 bzw. 26_2 erzeugen die Ansteuersignale S'1 bzw. S'2 für die Leistungshalbleiterschalter T1 und T2 in Abhängigkeit von jeweiligen Steuersignalen S1 bzw. S2, die die Ansteuereinheiten von einer übergeordneten Steuereinrichtung empfangen. Die Steuereinrichtung ist in Fig. 2 nicht näher veranschaulicht, ist jedoch in Fig. 1 angezeigt und mit dem Bezugszeichen 27 versehen ist.

Erneut bezugnehmend auf Fig. 1 ist die Steuereinrichtung 27 dazu vorgesehen, auf der Basis der momentanen Betriebsbedingungen den Betrieb des Stromrichters 8 geeignet zu steuern. Die Steuerpfade sind in Fig. 1 der Übersichtlichkeit wegen durch gestrichelte Pfeile 28 angedeutet, die aus der Steuereinrichtung 27 heraustreten. Auf der Basis der Steuersignale S steuern die Ansteuereinrichtungen 26 die zugehörigen Leistungshalbleiterschalter T der Submodule 14 aller Stromrichterzweige 9a-f geeignet an, um aus der Netzspannung u_{N}(t) bzw. deren Transformierten an den Wechselspannungsanschlüssen 17a-c eine gewünschte Gleichspannung U_{dc} zwischen den Gleichspannungsanschlüssen 12, 13 des Stromrichters 8 zu erzeugen oder umgekehrt. Die hierzu geeigneten Steuer- bzw. Schaltsignale S werden von der Steuereinrichtung 27 in Abhängigkeit von den aktuellen Betriebsbedingungen bzw. Parametern bestimmt, die von einer hier nicht näher dargestellten Überwachungseinrichtung im Betrieb laufend gemessen bzw. ermittelt werden. In Fig. 1 sind Messpfade durch gestrichelte Pfeile 29 angedeutet, die in die Steuereinrichtung 27 eintreten. Es können bspw. Phasenspannungen und/oder Phasenströme an den Wechselspannungsanschlüssen 17a-c, Zweigströme in den Stromrichterzweigen 9a-f und/oder der Zwischenkreisstrom in dem Gleichspannungszwischenkreis, Potentiale an den Gleichspannungsanschlüssen 12, 13 zur Erfassung der Zwischenkreisspannung U_{dc} und/oder andere Größen direkt erfasst oder gemessen werden. Manche Größen können aus erfassten Größen mit allgemein bekannten Beziehungen für elektrische Ströme und Spannungen bestimmt werden.

Die Vielzahl von Leistungshalbleiterschaltern T in dem Stromrichter 8 können im Betrieb beträchtliche Verluste, einschließlich Schaltverluste und Leitverluste, erzeugen, die hohe Energieverluste und zusätzliche Betriebskosten des Stromrichters hervorrufen können. Insofern ist es wichtig, die Verluste einzelner Leistungshalbleiterschalter T zu minimieren, um die Gesamtverluste deutlich zu senken. Dies wird durch die erfindungsgemäße Ansteuerung der Leistungshalbleiterschalter T erzielt.

Fig. 3 zeigt einen Leistungshalbleiterschalter T mit zugehöriger Ansteuereinrichtung 26 in größerer Detailtiefe. Wie aus Fig. 3 hervorgeht, kann die Ansteuereinrichtung 26 vorzugsweise in unmittelbarer Nähe des zugehörigen Leistungshalbleiterschalters T, bspw. auf der gleichen Leiterplatte, auf einen gemeinsamen Montagerahmen oder in sonstiger Weise nahe zu diesem angeordnet sein. Um die Schaltbefehle bzw. Steuersignale S von der übergeordneten Steuereinrichtung 27 zu empfangen, die von der Ansteuereinrichtung 26 weiter entfernt oder auch eine externe Steuerung sein kann, weist die Ansteuereinrichtung 26 einen Eingangsanschluss 32 auf, der über eine Steuerleitung 28 mit der Steuereinrichtung 27 verbunden sein kann.

Wie aus Fig. 3 hervorgeht, weist die Ansteuereinheit in der dargestellten Ausführungsform eine Zeitkontrolleinrichtung 33, eine Spannungserfassungseinrichtung 34 und eine Stromerfassungseinrichtung 36 auf. Wenngleich die Einrichtungen 33-36 hier allesamt als in der Ansteuereinrichtung 26 vorhanden dargestellt sind, müssen nicht alle Einrichtungen 33-36 gemeinsam vorgesehen sein. Prinzipiell genügt eine der Einrichtung 33, 34 und 36, um das erfindungsgemäße Ansteuerverfahren zu implementieren. Jedenfalls weist die Ansteuereinrichtung 26 ferner eine Auswerteeinheit 37, die dazu eingerichtet ist, von den Einrichtungen 33, 34 bzw. 36 empfangene Signale auszuwerten, und eine Treibereinrichtung 38 auf, die dazu eingerichtet ist, ein geeignetes Ansteuersignal S` zu erzeugen, das an den Gate-Anschluss G des Leistungshalbleiterschalters T angelegt wird.

Die Zeitkontrolleinrichtung 33 dient dazu, die Zeitdauer seit dem Empfang eines Schaltbefehls S von der Steuereinrichtung 27 bzw. seit dem Anlegen einer Ansteuerspannung S` an den Gate-Anschluss G des Leistungshalbleiterschalters T zu erfassen und ein die Zeitdauer kennzeichnendes Signal an die Auswerteeinrichtung 37 zu liefern.

Die Spannungserfassungseinrichtung dient dazu, Spannungspotentiale an dem Kollektor-Anschluss C und/oder dem Gate-Anschluss G des Leistungshalbleiterschalters T gegenüber dem Emitter-Anschluss E bzw. dem internen Emitterpotential e der Treiberschaltung, dessen Potential vorzugsweise für die Spannungsmessungen als Bezugspotential dient, zu erfassen und hierfür kennzeichnende Spannungsmesssignale an die Auswerteeinrichtung zu senden. Die Spannungserfassung kann direkt an dem jeweiligen Anschluss bspw. mit Hilfe eines Spannungsteilers vorgenommen werden. Alternativ können manche Spannungen ausgehend von anderen gemessenen Parametern in der Schaltung indirekt bestimmt werden.

Die Stromerfassungseinrichtung 36 ist dazu eingerichtet, den Laststrom durch den Leistungshalbleiterschalter T zu erfassen, der hier der Kollektorstrom I_{c} ist, der gleich dem Emitterstrom I_{E} ist. Zur Stromerfassung ist vorzugsweise an dem Emitter-Anschluss E des Leistungshalbleiterschalters T ein Stromsensor 39 vorgesehen. Die Stromerfassung kann auch bei Kenntnis des Wertes der parasitären Induktivität zwischen dem Hilfs- und Hauptemitteranschluss des Halbleiterleistungsschalters durch Integration der Spannung oder durch eine Spannungsmessung an einem Shunt-Widerstand bestimmt werden. Die Stromerfassungseinrichtung 36 sendet ein den Last- bzw. Kollektorstrom I_{c} kennzeichnendes Stromsignal an die Auswerteeinrichtung 37.

Die Auswerteeinrichtung 37 empfängt die von der Zeitkontrolleinrichtung 33, der Spannungserfassungseinrichtung 34 und der Stromerfassungseinrichtung 37 erfassten Messsignale sowie die EIN- und AUS-Schaltbefehle S und wertet diese Signale aus, um die Treibereinrichtung 38 anzuweisen, die jeweils erforderlichen Ansteuersignale S` zu generieren.

Insbesondere ist die Auswerteeinrichtung 37 dazu eingerichtet, in Abhängigkeit von einem EIN-Schaltbefehl S von der Steuereinrichtung 27 die Treibereinrichtung 38 zu veranlassen, den Leistungshalbleiterschalter T einzuschalten, und in Abhängigkeit von einem AUS-Schaltbefehl S von der Steuereinrichtung 27 die Treibereinrichtung 38 zu veranlassen, den Leistungshalbleiterschalter T auszuschalten. Die Auswerteeinrichtung 37 ist ferner dazu eingerichtet, anhand der von der Zeitkontrolleinrichtung 33, der Spannungserfassungseinrichtung 34 und der Stromerfassungseinrichtung 36 gelieferten Signale Bedingungen zu erkennen, die dafür kennzeichnend sind, dass der Einschaltvorgang als abgeschlossen gilt. In diesem Fall sendet die Auswerteeinrichtung 37 ein entsprechendes Auswertesignal an die Treibereinrichtung 38, das diese veranlasst, eine geeignete Ansteuerspannung für den Leitendzustand des Leistungshalbleiterschalters T an den Steueranschluss des Leistungshalbleiterschalters T anzulegen.

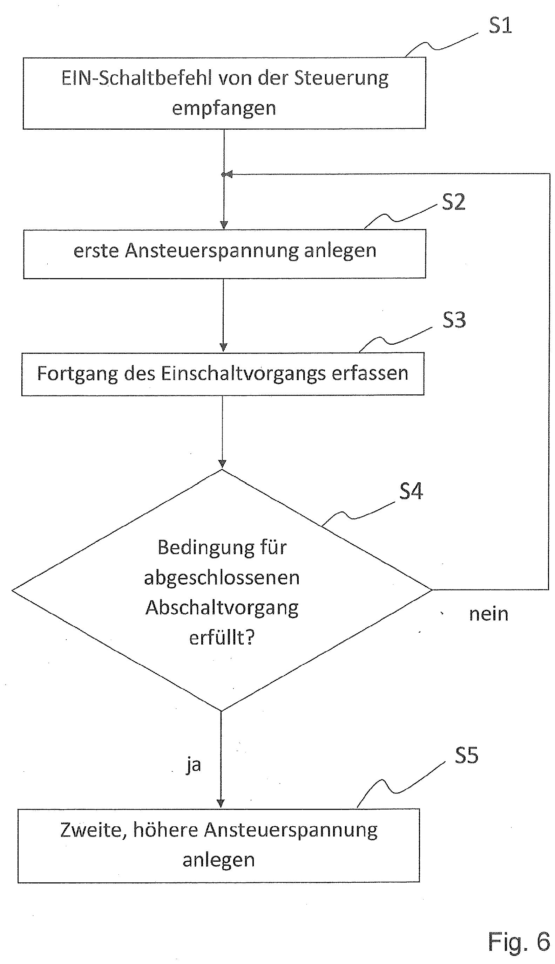

Während des Einschaltens des Leistungshalbleiters T wird eine erste Ansteuerspannung angelegt, die einen ersten Wert aufweist, während nach Erkennung, dass der Leistungshalbleiter T vollständig eingeschaltet oder durchgeschaltet ist, eine zweite Ansteuerspannung an den Steueranschluss G angelegt wird, die einen zweiten Wert aufweist, der höher ist als der erste Wert. In anderen Worten wird der Leistungshalbleiterschalter T im leitenden Zustand mit einer höheren Ansteuerspannung angesteuert. Die Logik der Auswerteeinrichtung 37 ist nachstehend im Zusammenhang mit Fig. 6 in weiteren Einzelheiten erläutert.

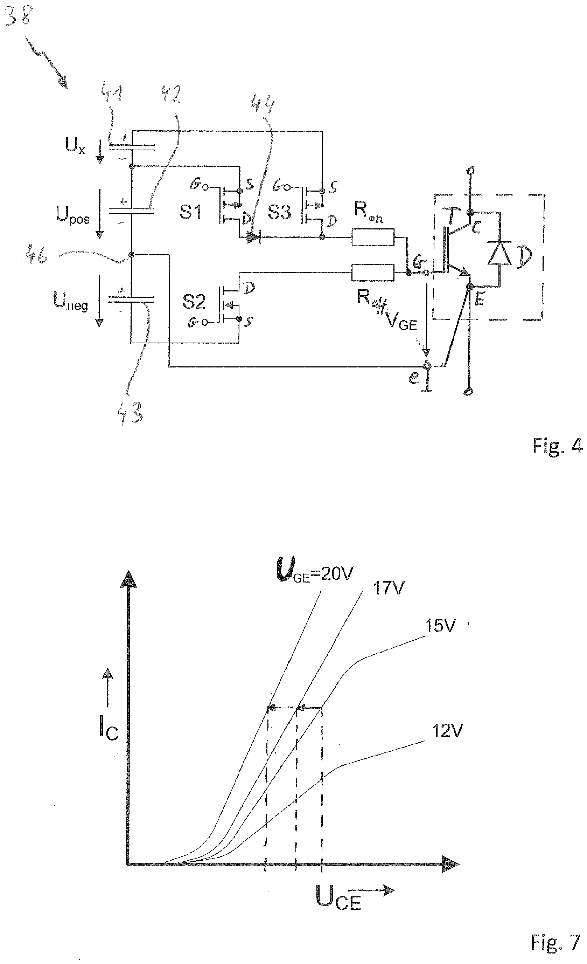

Die Treibereinrichtung 38 empfängt Auswertesignale von der Auswerteeinrichtung 37 und generiert in Abhängigkeit von diesen die jeweils geeigneten Ansteuersignale S' für den Leistungshalbleiterschalter T, um diesen geeignet einzuschalten, auszuschalten und im eingeschalteten Zustand zu betreiben. Die Treibereinrichtung 38 muss somit in der Lage sein, wenigstens zwei unterschiedliche positive Niveaus der Ansteuerspannung S' für den Leistungshalbleiterschalter T zu erzeugen. Eine beispielhafte Treibereinrichtung 38, die hierzu in der Lage ist, ist in Fig. 4 veranschaulicht.

Bezugnehmend auf Fig. 4 weist die dargestellte beispielhafte Treibereinrichtung 38 eine erste, eine zweite und eine dritte Spannungsquelle 41, 42, 43 auf, die mit gleicher Polarität in Reihe miteinander verbunden. Die erste Spannungsquelle 41 ist eine positive Spannungsquelle, die bedarfsweise, jedoch nicht notwendigerweise, eine variable Spannungsquelle sein kann, die abhängig von einem Betriebsmodus unterschiedliche positive Spannungswerte liefern kann. Es kann auch eine konstante Spannungsquelle 41 mit einem festen Spannungswert Uₓ vorgesehen sein.

Die zweite Spannungsquelle 42 (Uₚₒₛ) und die dritte Spannungsquelle 43 (U_{neg}) sind konstante Spannungsquellen, die gleiche oder auch unterschiedliche Spannungswerte aufweisen können. Bspw. kann Uₚₒₛ in etwa 10-15 V betragen, während U_{neg} etwa -5 V bis -15 V betragen kann. Uₚₒₛ bzw. U_{neg} bestimmen die Ansteuerspannungen, die beim Ein- bzw. Ausschalten des Leistungshalbleiterschalters T an den Gate-Anschluss angelegt werden.

Der Pluspol der zweiten Spannungsquelle 42 ist über einen ersten Schalter S1, der hier durch einen p-Kanal MOSFET gebildet ist, eine Diode 44 und einen Einschaltwiderstand Rₒₙ mit dem Gate-Anschluss G des Leistungshalbleiterschalters T verbunden. Die Diode 44 ist in Durchflussrichtung von dem Drain-Anschluss D des Schalters S1 in Richtung des Gate-Anschlusses G des Leistungshalbleiterschalters T mit dem Einschaltwiderstand Rₒₙ verbunden.

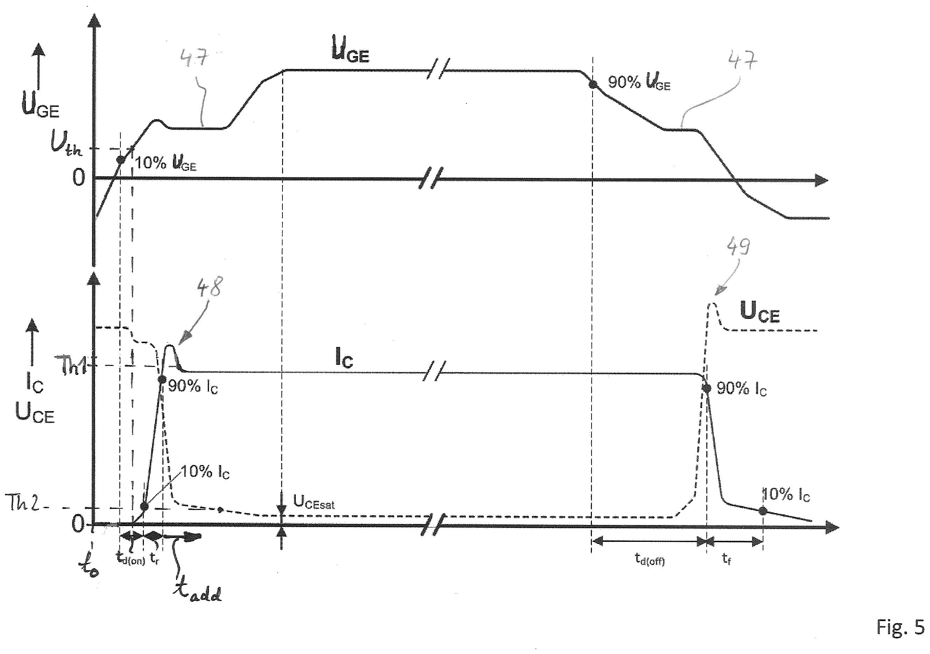

Der negative Pol der dritten Spannungsquelle 43 U_{neg} ist über einen zweiten Schalter S2 in Form eines p-Kanal-MOSFETs mit einem Ausschaltwiderstand R_{off} verbunden, der einerseits mit dem Drain-Anschluss D des zweiten Schalters S2 und andererseits mit dem Gate-Anschluss G des Leistungshalbleiterschalters T verbunden ist. Die Ein- und Ausschaltwiderstände Rₒₙ und R_{off} können geeignet gewählt werden, um die Schaltvorgänge zu optimieren. Die Schaltvorgänge sind im Zusammenhang mit Fig. 5 nachstehend näher erläutert.

Wie ferner aus Fig. 4 ersichtlich, ist der Verbindungspunkt 46 zwischen der zweiten und der dritten Spannungsquelle 42, 43 mit dem Emitter E des Leistungshalbleiterschalters T verbunden und dient als lokaler Bezugspunkt e für die Ansteuerschaltung wie auch für die Treibereinrichtung 38. Der Emitter E des Leistungshalbeiterschalters T und der lokale Bezugspunkt e können auch durch einen zusätzlichen Widerstand für den Schaltbetrieb entkoppelt sein.

Der positive Pol der ersten Spannungsquelle 41 ist über einen dritten Schalter S3, der durch einen p-Kanal MOSFET gebildet ist, mit dem Verbindungspunkt zwischen der Kathode der Diode 44 und dem Einschaltwiderstand Rₒₙ verbunden.

Wenn der erste Schalter S1 eingeschaltet ist, während der zweite und der dritte Schalter S2, S3 ausgeschaltet sind, wird die Spannung Uₚₒₛ der zweiten Spannungsquelle 42 über die Diode 44 und den Einschaltwiderstand Rₒₙ an den Gate-Anschluss G des Leistungshalbleiterschalters T angelegt, um den Leistungshalbleiterschalter T einzuschalten. Wenn der zweite Schalter S2 eingeschaltet ist, während die anderen beiden Schalter S1 und S3 ausgeschaltet sind, wird die negative Spannung -U_{neg} der dritten Spannungsquelle 43 über den Schalter S2 und den Ausschaltwiderstand R_{off} an den Gate-Anschluss G des Leistungshalbleiterschalters T angelegt, um diesen auszuschalten. Wenn der dritte Schalter S3 eingeschaltet ist, während zumindest der Schalter S2 ausgeschaltet ist (Schalter S1 kann auch eingeschaltet bleiben), wird die Summenspannung Uₓ + Uₚₒₛ der ersten und zweiten Spannungsquelle 41, 42 über den Schalter S3 und den Einschaltwiderstand Rₒₙ auf den Gate-Anschluss G des Leistungshalbleiterschalters T angelegt. Dies erfolgt gemäß der Erfindung, sobald Bedingungen erfasst sind, die anzeigen, dass der Einschaltvorgang abgeschlossen, der Leistungshalbleiterschalter T also durchgeschaltet ist.

Zur Verdeutlichung der Funktionsweise der erfindungsgemäßen Ansteuereinrichtung 26 wird zunächst auf Fig. 5 Bezug genommen, die zeitlichen Verläufe der Gate-Emitter-Spannung U_{GE}, der Kollektor-Emitter-Spannung U_{CE} und des Kollektorstroms I_{c} beim Einschalten, Ausschalten und während des leitenden Zustands eines IGBTs veranschaulicht. Die Ausführungen gelten für einen MOSFET in ähnlicher Weise. Wird zum Zeitpunkt t₀ der IGBT durch Anlegen einer Gatespannung U_{G} eingeschaltet, so steigt die Gate-Emitter-Spannung U_{GE} zunächst leicht verzögert an, wird positiv, erreicht 10 % ihres Wertes und anschließend die sog. Thresholdspannung Uₜₕ, bei der der IGBT beginnt, Strom zu leiten. Die Kollektor-Emitter-Spannung U_{CE} zeigt eine Verringerung der Spannung um den Anteil, der an der Kommutierungskreisinduktivität abfällt. Der Kollektorstrom I_{c} fängt dementsprechend erst nach einer Einschaltverzögerung t_{d(on)} an zu steigen. Die Einschaltverzögerung t_{d(on)} wird zwischen dem Zeitpunkt, in dem die Gate-Emitter-Spannung bei einem IGBT (bzw. die Gate-Source-Spannung bei einem MOSFET) in etwa 10% beträgt und dem Zeitpunkt definiert, in dem der Kollektorstrom I_{c} (bzw. Drainstrom I_{D}) etwa 10% seines stationären Nennwertes beträgt.

Die Gate-Emitter-Spannung U_{GE} steigt nicht unmittelbar auf den angelegten Endwert an, sondern erreicht zunächst das sogenannte "Miller-Plateau" 47, auf dem die Gate-Emitter-Spannung zunächst konstant bleibt. Bis zu diesem Zeitpunkt steigt der Strom im IGBT an. Beim Erreichen des Millerplateaus beginnt die kommutierende Diode, Spannung aufzunehmen, wodurch die Kollektor-Emitter-Spannung des IGBTs fällt. Zu diesem Zeitpunkt tritt der sog. Reverse-Recovery-Effekt an der kommutierenden Diode auf, der sich als Strom- bzw. Rückstromspitze 48 auf dem Kollektorstrom des IGBTs abbildet. Die in die Gate-Elektrode einfließenden Ladungsträger werden in diesem Zeitraum zum Umladen der Gate-Kollektor-Kapazität des IGBTs (bzw. Gate-Drain-Kapazität des MOSFETs) verwendet. Während des Miller-Plateaus 47 sinkt die Kollektor-Emitter-Spannung U_{CE} zunächst mit einer ersten, hohen Kollektor-Emitter-Spannungsänderungsgeschwindigkeit dU_{ce}/dt und anschließend mit einem geringeren dU_{ce}/dt-Wert ab, bis sie ihren endgültigen Wert U_{CEsat} erreicht, bei dem der Leistungshalbleiterschalter vollkommen eingeschaltet bzw. durchgeschaltet ist.

Die Zeitdauer von dem Zeitpunkt, in dem der Kollektorstrom 10% des Nennstroms beträgt, bis zu dem Zeitpunkt, in dem er 90% des Nennstroms beträgt, wird als Anstiegszeit tᵣ bezeichnet. Nach der Umladung bzw. dem Ende des Miller-Plateaus steigt die Gate-Emitter-Spannung U_{GE} auf den endgültigen Wert an, der durch den Gate-Treiber, z.B. die Treibereinrichtung 38, angelegt wurde. Nach Erreichen des endgültigen Wertes der Gate-Emitter-Spannung ist das Bauelement vollständig eingeschaltet und die Kollektor-Emitter-Spannung hat U_{CEsat} erreicht.

Beim Abschalten fällt die Gate-Emitter-Spannung U_{GE} analog zunächst auf das Miller-Plateau 47 ab, auf dem sie für kurze Zeit verbleibt, bevor sie auf den angelegten Wert, meist ein negativer Wert von -5 bis -15 V, abfällt. Die Spannung U_{CE} steigt an und durchläuft eine Abschaltüberspannung 49, die von der angelegten Gate-Emitter-Spannung U_{GE} und der Kollektorstromänderungsgeschwindigkeit dI_{c/}dt und der Kommutierungskreisinduktivität abhängig ist. Der Kollektorstrom I_{c} fängt erst nach einer Abschaltzögerung t_{d(off)} nach dem Abschalten an zu fallen. Der Zeitraum t_{f} zwischen dem Zeitpunkt, in dem der Kollektorstrom I_{c} 90% des Nennwertes beträgt und dem Zeitpunkt, in dem er 10% des Nennwertes beträgt, wird als Fallzeit t_{f} bezeichnet. Die Einschaltverzögerung t_{d(on)}, die Anstiegszeit tᵣ, die Kollektorstromänderungsgeschwindigkeit, die Abschaltverzögerung t_{d(off)}, die Fallzeit t_{f}, die Fallrate, etc., wie sie in Fig. 5 dargestellt sind, sind für einen bestimmten Leistungshalbleitertyp charakteristisch und in zugehörigen Datenblättern spezifiziert oder können durch Messung am Stromrichter oder Stromrichterkomponenten für entsprechende Schaltbedingungen bestimmt werden. Faktoren, wie Temperatur, Strom, Spannung und der Gatetreiber, haben einen Einfluss auf diese Zeiten.

In der Technik sind zahlreiche Methoden vorgeschlagen worden, um durch mehrstufiges Einschalten, durch optimierte Gatestromprofile oder Gatespannungsverläufe, durch Auslegung der Ein- und Ausschaltwiderstände und durch Steuerung der Kollektor-Emitter-Spannungsänderungsgeschwindigkeit und/oder der Kollektorstromänderungsgeschwindigkeit eines IGBTs während eines Schaltvorgangs die Schalttransienten zu optimieren, um dadurch unter anderem die Schaltverluste zu minimieren. All diese Methoden sind auf die Optimierung des Schaltverhaltens bzw. der Schaltvorgänge als solche gerichtet. Die Erfindung zielt hingegen auf eine Optimierung des Leitendbetriebs eines Leistungshalbleiterschalters ab, um dadurch Leitverluste zu minimieren. Dies soll anhand der Fig. 6 näher beschrieben werden.

Fig. 6 zeigt ein erfindungsgemäßes Verfahren zur Ansteuerung eines spannungsgesteuerten wiederabschaltbaren Leistungshalbleiterschalters, bspw. der in den Figuren 2-4 dargestellten Leistungshalbleiterschalter T, T1, T2, die insbesondere IGBTs oder MOSFETs oder andere spannungsgesteuerte wiederabschaltbare Leistungshalbleiterschalter sein können, die durch Anlegen einer Ansteuerspannung an ihren Steueranschluss, den Gate-Anschluss, ein- und ausgeschaltet werden können, wobei sie im eingeschalteten Zustand einen Strom, insbesondere Kollektorstrom, zwischen einem ersten und einem zweiten Anschluss, z.B. dem Kollektor und dem Emitter, führen.

Das Verfahren beginnt im Schritt S1, in dem ein Steuersignal, insbesondere ein EIN-Schaltbefehl S von einer übergeordneten Steuerung, insbesondere der Steuereinrichtung 27 empfangen wird. Der EIN-Schaltbefehl wird bspw. von der in Fig. 3 dargestellten Zeitkontrolleinrichtung 33 und der Auswerteeinrichtung 27 empfangen. Die Auswerteeinrichtung 37 kann dann im Wesentlichen unverzüglich die Treibereinrichtung 38 veranlassen, den Leistungshalbleiterschalter T einzuschalten.

Zum Einschalten des Leistungshalbleiterschalters T wird, wie im Schritt S2 in Fig. 6 veranschaulicht, eine erste Ansteuerspannung, insbesondere Gate-Spannung, die einen ersten Wert aufweist, an den Steueranschluss (Gate) des Leistungshalbleiterschalters T angelegt. Der erste Wert kann bspw. 10 V - 15 V betragen. Durch das Anlegen der Ansteuerspannung wird der Leistungshalbleiterschalter T in der in Verbindung mit Fig. 5 beschriebenen Weise eingeschaltet.

Die Auswerteeinrichtung 37 kann auch mit einer festgelegten Verzögerung die Treibereinrichtung 38 anweisen, den Leistungshalbleiterschalter einzuschalten. In diesem Fall meldet die Auswerteeinrichtung der Zeitkontrolleinrichtung den Zeitpunkt, zu dem die erste Ansteuerspannung an den Steueranschluss des Leistungshalbleiterschalters angelegt wird. Die Zeitkontrolleinrichtung 33 beginnt dann vorzugsweise die Zeitmessung mit diesem Ereignis des Anlegens der ersten Ansteuerspannung.

Im Schritt S3 werden Bedingungen, die den Fortgang des Einschaltvorgangs des Leistungshalbleiterschalters kennzeichnen, erfasst. Bspw. erfasst die Zeitkontrolleinrichtung 33 die Zeitdauer seit dem Anlegen der ersten Ansteuerspannung. Alternativ oder zusätzlich kann die Spannungserfassungseinrichtung 34 den momentanen Wert der Kollektor-Emitter-Spannung U_{CE} bzw. der Gate-Emitter-Spannung U_{GE} messen oder bestimmen. Als weitere Alternative oder weiter zusätzlich kann der Laststrom durch den Leistungshalbleiterschalter, also der Kollektorstrom I_{c}, mittels der Stromerfassungseinrichtung 36 gemessen oder bestimmt werden. Das oder die Signale von der Zeitkontrolleinrichtung 33, der Spannungserfassungseinrichtung 34 und/oder der Stromerfassungseinrichtung 36 werden der Auswerteeinrichtung 37 zur Überwachung zugeführt.

Im Schritt S4 wird überprüft, ob Bedingungen vorliegen, die dafür kennzeichnend sind, dass der Einschaltvorgang als abgeschlossen gilt. Dies kann auf vielfältige Weise geschehen.

In einer Ausführungsform kann bspw. das Signal von der Stromerfassungseinrichtung 36 ausgewertet werden, das den Strom des Leistungshalbleiterschalters, also bspw. den Kollektorstrom I_{c}, kennzeichnet. Hat der Strom I_{c} eine Rückstromspitze, die der ihm zugehörigen kommutierenden Diode entspricht, wie bspw. die Stromspitze 48 in Fig. 5, durchlaufen und ist er wieder auf einen ersten Schwellenwert Th1 abgefallen, bei dem die Kollektorstromänderungsgeschwindigkeit dI_{c/}dt betragsmäßig weniger als 20 %, vorzugsweise weniger als 10 % des Stromanstiegs von 10 % bis 90 % des Stroms I_{c} beim Einschalten des Leistungshalbleiterschalters T (Zeitraum tᵣ in Fig. 5) beträgt, kann der Leistungshalbleiterschalter T als vollständig eingeschaltet angesehen werden. Dann kann die höhere, zweite Ansteuerspannung angelegt werden.

Die auf einer Auswertung des Kollektorstroms basierenden Ausführungsformen können sehr effektiv sein, wegen der erforderlichen Kollektorstromerfassung aber relativ aufwändig zu implementieren sein.

In anderen, mehr bevorzugten Ausführungsformen wird die gemessene Durchlassspannung des Leistungshalbleiterschalters, also z.B. die Kollektor-Emitter-Spannung U_{CE} zur Überprüfung, ob der Einschaltvorgang als abgeschlossen gilt, herangezogen. Wenn die Durchlassspannung einen zweiten Schwellenwert Th2 erreicht oder unterschreitet, der dafür kennzeichnend ist, dass der Leistungshalbleiterschalter eingeschaltet ist, wird zum Schritt S5 übergegangen.

Der zweite Schwellenwert Th2 kann in Abhängigkeit von der maximal möglichen Durchlassspannung an dem Leistungshalbleiterschalter im leitenden Zustand festgelegt werden. Durch Messungen kann die für den regulären Betrieb maximal mögliche Durchlassspannung ermittelt werden. Unter Berücksichtigung von Messunsicherheiten der Vorrichtung, dem Zeitverhalten und der Streuung der Halbleiterbauelemente kann dann der zweite Schwellwert Th2 gewählt werden. Einflussfaktoren können hier die Abhängigkeit des Schaltverhaltens von der Ansteuerspannung, den Gate-Widerständen, der Streu- bzw. Kommutierungskreisinduktivität der Schaltung, den Wärmebedingungen im Betrieb, und andere sein. Der zweite Schwellenwert Th2 kann im Bereich von 10 V bis 0,5 V liegen, vorzugsweise ist er kleiner als 5 V.

In noch weiteren, ebenfalls vorteilhaften Ausführungsformen kann die Spannung an der Steuerelektrode, z.B. die Gate-Spannung, zur Erfassung von Bedingungen, die dafür kennzeichnend sind, dass der Einschaltvorgang als abgeschlossen gilt, herangezogen werden. Wenn die Spannung an der Steuerelektrode einen dritten Schwellenwert Th3 erreicht oder überschreitet, der höher ist als ein Wert des Miller Plateaus der Ansteuerspannung, bspw. des Miller-Plateaus 47 in Fig. 5, kann die vorgenannte Bedingung als erfüllt angesehen werden. Der dritte Schwellenwert kann vorzugsweise mindestens 90% des Wertes der angelegten ersten Ansteuerspannung betragen. Vorteilhafterweise kann er auch mehr als 95% des Wertes der ersten Ansteuerspannung betragen.

In besonders bevorzugten Ausführungsformen wird die Zeitdauer seit dem Zeitpunkt des Anlegens der ersten Ansteuerspannung erfasst und zur Überprüfung der Bedingung, die dafür kennzeichnend ist, dass der Einschaltvorgang als abgeschlossen gilt, herangezogen. Wenn die Zeitdauer die spezifizierte Zeitschwelle tₜₕ = t_{td(on)} + tᵣ + t_{add} überschreitet, wird die vorgenannte Bedingung als erfüllt angesehen. Dabei ist t_{d(on)} die Einschaltverzögerung, wie in Fig. 5 veranschaulicht, während tᵣ die Anstiegszeit des Stromes, z.B. Kollektorstromes, des Leistungshalbleiterschalters ist. Diese Parameter sind in Datenblättern für die jeweiligen Leistungshalbleitertypen spezifiziert oder können durch Messung am Stromrichter oder an Stromrichterbestandteilen bestimmt werden. t_{add} ist eine zusätzliche Zeitkonstante, die eine Sicherheitsreserve schafft und die vom Verhalten des Gatetreibers abhängige Zeitdauer zwischen dem Anlegen der Gatespannung und dem Zeitpunkt des Erreichens von 10% des Kollektorstroms I_{c} und auch mögliche Kurzschlussmaßnahmen bzw. -überprüfungen berücksichtigen kann, die während und kurz nach dem Einschaltvorgang aktiv sein können. Wie aus Fig. 5 hervorgeht, kann durch die zusätzliche Zeitkonstante t_{add} der Zeitpunkt, in dem die Bedingung als erfüllt angesehen wird, in den Bereich des Anstiegs der Gate-Emitter-Spannung von dem Miller-Plateau 47 auf den stationären Wert bzw. in den Bereich nach der Stromspritze 48 gelegt werden. Die Zeitkonstante t_{add} kann bspw. 0 bis 20 µs betragen. Vorzugsweise beträgt sie zwischen 5 und 15 µs.

Solange im Schritt S4 in Fig. 6 erfasst wird, dass die Bedingung für den eingeschalteten Leistungshalbleiterschalter nicht erfüllt ist (nein), kehrt der Prozess zum Schritt S2 zurück, wobei die erste Ansteuerspannung weiterhin angelegt bleibt.

Sobald im Schritt S4 erfasst wird, dass die Bedingung für den eingeschalteten Leistungshalbleiterschalter erfüllt ist (ja), schreitet das Verfahren zum Schritt S5 fort. Im Schritt S5 wird dann eine zweite Ansteuerspannung, die einen zweiten Wert aufweist, der höher ist als der erste Wert, an den Steueranschluss des Leistungshalbleiterschalters angelegt, um diesen im leitenden Zustand zu betreiben.

Bspw. kann die zweite Ansteuerspannung im Bereich zwischen 15 V und 20 V liegen. Insbesondere kann sie, wenn die erste Ansteuerspannung 15 V beträgt, 17 V betragen.

In Fig. 7 ist die Ausgangscharakteristik für einen Leistungshalbleiterschalter, insbesondere einen IGBT, für unterschiedliche Gate-Emitter-Spannungen U_{GE} von 12 V, 15 V, 17 V und 20 V veranschaulicht. Es ist der Kollektorstrom I_{c} über der Kollektor-Emitter-Spannung U_{CE} dargestellt, wobei im Wesentlichen die Sättigungsbereiche in dieser Darstellung von Interesse sind. Mit steigender Gate-Emitter-Spannung U_{GE} erhöht sich der Sättigungsstrom bzw. Sättigungsbereich des Kollektorstroms I_{c} gegenüber der Spannung U_{CE}. Wird nun die Gate-Emitter-Spannung U_{GE} bspw. von 15 V auf 17 V im leitenden, durchgeschalteten Zustand des Leistungshalbleiterschalters erhöht, so wird der Spannungssättigungsbereich erhöht, und die Durchlassspannung U_{CE} des Leistungshalbleiterschalters verringert sich. Dies hat geringere Leitverluste des Leistungshalbleiterschalters im leitenden Betrieb zur Folge. Der Kanalwiderstand des Leistungshalbleiterschalters sinkt und auch die Sperrschichttemperatur des Leistungshalbleiterschalters nimmt bei gegebenem Kollektorstrom ab. Dadurch können Maßnahmen, die zur Kühlung des Leistungshalbleiterschalters erforderlich sind, verringert werden, was Kostenreduktionen für die Implementierung zur Folge hat. Der Leistungshalbleiter kann auch kurzzeitige Überlastbedingungen besser bewältigen und muss im Vergleich zu einem Betrieb mit einer niedrigeren Gate-Emitter-Spannung weniger stark überdimensioniert werden. Die reduzierten Leitverluste, Dimensionierungs- und Raumerfordernisse wirken sich bei Stromrichtern, wie bspw. dem Stromrichter nach Fig. 1, oder anderen Stromrichtern oder Einrichtungen, die eine Vielzahl von Leistungshalbleiterschaltern im Pulsbetrieb verwenden, besonders vorteilhaft aus.

In bevorzugten Ausführungsformen wird eine höhere Ansteuerspannung U_{GE} als 17 V von bspw. 20 V gewählt. Falls gewünscht, kann die Ansteuerspannung sogar höher sein als der für den Dauerbetrieb des IGBTs bzw. MOSFETs spezifizierte Parameter. Bspw. kann die Ansteuerspannung mehr als 20 V oder sogar mehr als 30 V betragen.

Im Rahmen der Erfindung sind zahlreiche Modifikationen möglich. Bspw. sind die Vorrichtung und das Verfahren gemäß der Erfindung zur Ansteuerung von Leistungshalbleiterschaltern nicht nur in modularen Stromrichtern, wie veranschaulicht, sondern in beliebigen Stromrichtertopologien, auch in konventionellen 2-Level- und 3-Level-Stromrichtern, und in anderen Anwendungen geeignet. Auch sind zahlreiche Treiberschaltungen bekannt bzw. Stand der Technik, die in der Lage sind, eine hier benötigte mehrstufige Ansteuerspannung an die Steuerelektrode eines Leistungshalbleiterschalters anzulegen.

In einer Weiterbildung des Verfahrens kann nach der Erfassung von Bedingungen, bspw. Zeit- oder Strombedingungen, die dafür kennzeichnend sind, dass der Einschaltvorgang als abgeschlossen gilt, zunächst noch überprüft werden, ob die Durchlassspannung U_{CE} oder der Kollektorstrom I_{c} einen vorgegebenen vierten Schwellenwert überschreitet. Der vierte Schwellenwert für die Durchlassspannung U_{CE} kann größer als der zweite Schwellenwert sein und bspw. 5-10 V betragen. Der vierte Schwellenwert für den Kollektorstrom I_{C} kann einem Wert bspw. oberhalb des Nennstroms des Halbeiterbauelements entsprechen. Ein Vorliegen einer derart hohen Durchlassspannung U_{CE} bzw. eines derart hohen Kollektorstroms weist dann auf eine Überlastbedingung hin, wobei die zweite Ansteuerspannung nur dann angelegt wird, falls festgestellt wird, dass Überlastbedingungen vorliegen. Dann können kurzzeitige Überlasten oder andere kritische Situationen besser bewältigt und begleitende Verluste reduziert werden.

Ferner kann das Abschalten des Leistungshalbleiterschalters ebenfalls zweistufig erfolgen, indem zunächst an den Steueranschluss, z.B. den Gate-Anschluss G, eine erste Ansteuerspannung angelegt wird, die kleiner als die zweite Ansteuerspannung im leitenden Betrieb ist und vorzugsweise in etwa der ersten Ansteuerspannung entspricht, während nach Ablauf einer vorgegebenen Zeitdauer eine zum sicheren Abschalten des Leistungshalbleiterschalters geeignete Spannung, insbesondere eine negative Spannung im Bereich von -5 V bis -15 V, angelegt wird.

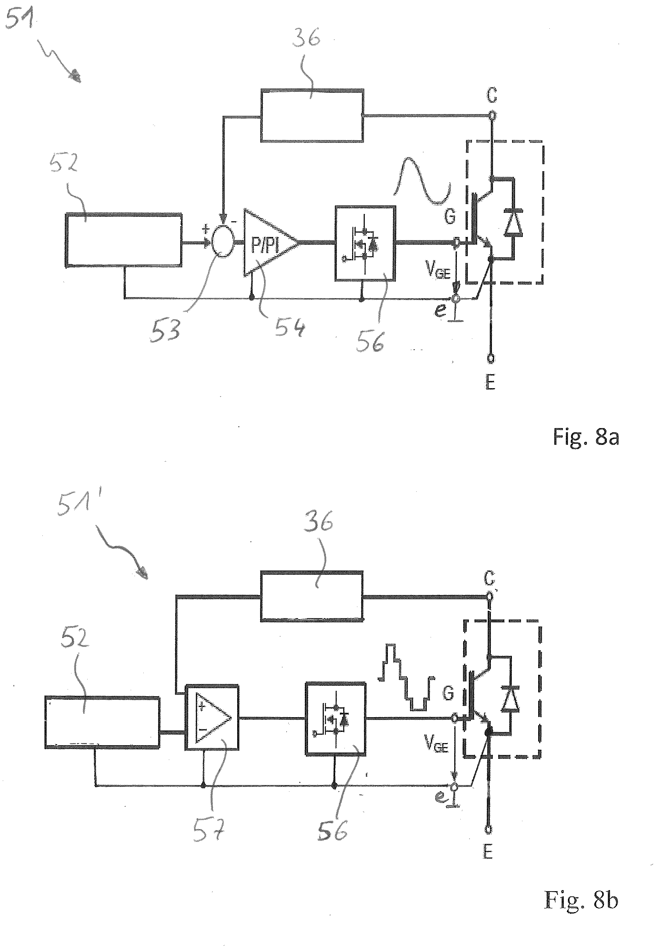

Das erfindungsgemäße Prinzip und eine mögliche Implementierung der Erfindung ist in den Figuren 8a und 8b veranschaulicht. Gemäß der Erfindung wird die an die Steuerelektrode G des Leistungshalbleiterschalters T angelegte Spannung auf den zweiten Wert der zweiten Ansteuerspannung während des leitenden Zustands des Leistungshalbleiterschalters T in einer geschlossenen Regelschleife einer Regeleinrichtung geregelt. Die Regeleinrichtung 51 in Fig. 8a weist die Spannungserfassungseinrichtung 36 auf, die die Durchlassspannung U_{CE} des Leistungshalbleiterschalters T erfasst. Eine Referenzeinheit 52 liefert den Sollwert bzw. die Führungsgröße für die Durchlassspannung. Ein Addierer 53 bestimmt die Regelabweichung bzw. die Differenz zwischen dem Sollwert und dem Istwert der Durchlassspannung U_{CE} und liefert die Regelabweichung an einen Regler 54. Der Regler 54 kann ein Proportional(P)- oder vorzugsweise ein Proportional-Integral(PI)-Regler sein. Der Ausgang des Reglers 54 gibt die allgemeine Stellgröße auf einen mehrstufigen Verstärker 56, der als Stellglied die entsprechend verstärkte Gate-Emitter-Spannung erzeugt und an den Gate-Anschluss G des Leistungshalbleiterschalters T anlegt. Anstelle des mehrstufigen Verstärkers kann auch eine variable Stromquelle oder Spannungsquelle verwendet werden.

Die in Fig. 8b dargestellte Regeleinrichtung 51` unterscheidet sich von der in Fig. 8a im Wesentlichen nur dadurch, dass hier der Addierer 53 und der PI-Regler 54 durch einen Komparator 57 ersetzt sind, der den Sollwert und den Istwert der Durchlassspannung U_{CE} vergleicht und an seinem Ausgang ein positives oder ein negatives Signal (bzw. ein Nullsignal) liefert, je nachdem ob der Sollwert größer oder kleiner als der Istwert ist. In Abhängigkeit von dem Vergleichsergebnis des Komparators 57 setzt der mehrstufige Verstärker 56 die Ansteuerspannung für den Gate-Anschluss G des Leistungshalbleiterschalters T dann um eine Stufe herauf oder herab.

Auf diese Weise kann die Durchlassspannung U_{CE} auf den gewünschten Wert in bestimmten Grenzen der Ausgangscharakteristik des Leistungshalbleiters und in kontrollierter Weise geregelt werden. Zu hohe Kollektorstromänderungsgeschwindigkeiten während der Schaltvorgänge durch einstufiges Schalten können vermieden werden. Die Regelung kann analog oder digital implementiert sein. Anstelle der Durchlassspannung U_{CE} kann auch der Laststrom I_{C} als Mess- und/oder Regelgröße herangezogen werden.

Im Übrigen kann die erfindungsgemäße Ansteuereinrichtung 26 in analoger oder digitaler Form realisiert werden. Eine digitale Realisierung kann auf der Basis einer FPGA oder eines Mikrocomputers erfolgen. Der Algorithmus mit dem erfindungsgemäßen Ansteuerverfahren, wie er in Verbindung mit Fig. 6 näher beschrieben ist, kann in Form von Computer ausführbaren Instruktionen verkörpert sein, die in Form eines Computerprogrammproduktes verteilt und verwendet werden können, das ein Computer lesbares Medium aufweist, das diese Instruktionen speichert. Als ein Beispiel kann ein Computer lesbares Medium Computerspeichermedien und Kommunikationsmedien umfassen. Wie für Fachleute auf dem Gebiet bekannt, enthalten Computerspeichermedien sowohl flüchtige als auch nichtflüchtige, auswechselbare und nicht auswechselbare Medien, die durch ein beliebiges Verfahren und in einer beliebigen Technologie zur Speicherung von Informationen, bspw. Computer lesbaren Informationen, Datenstrukturen, Programmmodulen oder anderen Daten, implementiert sind. Computerspeichermedien umfassen, ohne jedoch darauf beschränkt zu sein, RAM, ROM, EEPROM, Flash-Speicher oder andere Speichertechnologien, CD-ROM, DVD oder optische Scheibenspeicher, Magnetkassetten, Magnetbänder und andere Magnetspeichervorrichtungen. Ferner ist es für Fachleute auf dem Gebiet bekannt, dass Kommunikationsmedien gewöhnlich Computer lesbare Instruktionen, Datenstrukturen, Programmmodule oder andere Daten in Form eines modulierten Datensignals, z.B. einer modulierten Trägerwelle oder eines anderen Transportmechanismus, verkörpern und beliebige Informationsübertragungsmedien umfassen können.

Es sind ein Verfahren und eine Vorrichtung zur Ansteuerung eines IGBTs oder eines MOSFETs oder eines sonstigen spannungsgesteuerten, wiederabschaltbaren Leistungshalbleiterschalters T, der einen ersten und einen zweiten Anschluss C, E sowie einen Steueranschluss G aufweist und der im eingeschalteten Zustand zwischen dem ersten und dem zweiten Anschluss C, E leitend ist, geschaffen. Zunächst wird eine erste Ansteuerspannung, die einen ersten Wert aufweist, an den Steueranschluss G angelegt, um den Leistungshalbleiterschalter T einzuschalten, S2. Anschließend werden Bedingungen erfasst, die den Fortgang eines Einschaltvorgangs des Leistungshalbleiterschalters T kennzeichnen, S3. Sobald Bedingungen erfasst sind, die dafür kennzeichnend sind, dass der Einschaltvorgang als abgeschlossen gilt, S4, wird eine zweite Ansteuerspannung, die einen zweiten Wert aufweist, der höher ist als der erste Wert, an den Steueranschluss G angelegt, um den Leistungshalbleiterschalter T im leitenden Zustand mit einer höheren Ansteuerspannung zu betreiben S5, um dessen Leitverluste zu reduzieren.

## Patentansprüche

1. Verfahren zur Ansteuerung eines spannungsgesteuerten wiederabschaltbaren Leistungshalbleiterschalters (T), der einen ersten und einen zweiten Anschluss (C, E) sowie einen Steueranschluss (G) aufweist, insbesondere eines IGBTs oder MOSFETs, wobei der Leistungshalbleiterschalter (T) im eingeschalteten Zustand zwischen dem ersten und dem zweiten Anschluss (C, E) leitend ist, wobei das Verfahren aufweist:
Anlegen einer ersten Ansteuerspannung, die einen ersten Wert aufweist, an den Steueranschluss (G), um den Leistungshalbleiterschalter (T) einzuschalten (S2), und
Erfassen von Bedingungen, die den Fortgang eines Einschaltvorgangs des Leistungshalbleiterschalters (T) kennzeichnen (S3), durch Erfassen wenigstens eines Betriebsparameters an dem Leistungshalbleiterschalter (T), wozu wenigstens ein Spannungspotential an einem der Anschlüsse (C, G, E) des Leistungshalbleiterschalters (T) und/oder der Laststrom (I_{C}) durch den Leistungshalbleiterschalter (T) gehören,
Erfassen von Bedingungen, die dafür kennzeichnend sind, dass der Einschaltvorgang als abgeschlossen gilt (S4), und
Anlegen einer zweiten Ansteuerspannung, die einen zweiten Wert aufweist, der höher ist als der erste Wert, an den Steueranschluss (G), um den Leistungshalbleiterschalter (T) im leitenden Zustand zu betreiben (S5), sobald Bedingungen erfasst sind, die dafür kennzeichnend sind, dass der Einschaltvorgang als abgeschlossen gilt (S4),
wobei die an den Steueranschluss (G) des Leistungshalbleiterschalters (T) angelegte zweite Ansteuerspannung auf den zweiten Wert in einer geschlossenen Regelschleife (51, 51`) geregelt wird, wobei die gemessene Durchlassspannung (U_{CE}) und/oder der gemessene Laststrom (I_{c}) des Leistungshalbleiterschalters (T) die zur Rückführung für die Regelschleife dienende Messgröße bildet, und
wobei das Erfassen von Bedingungen, die dafür kennzeichnend sind, dass der Einschaltvorgang als abgeschlossen gilt (S4), aufweist, dass wenigstens eines der folgenden Kriterien erfüllt ist:
dass erfasst wird, dass die Spannung (U_{GE}) an dem Steueranschluss (G) einen dritten Schwellenwert (Th3) erreicht oder überschreitet, der höher ist als ein Wert eines Miller-Plateaus (47) der Ansteuerspannung und mindestens 90% des Wertes der ersten Ansteuerspannung beträgt;
dass erfasst wird, dass die Durchlassspannung zwischen dem ersten und dem zweiten Anschluss (C, E) einen zweiten Schwellenwert (Th2) erreicht oder unterschreitet, der dafür kennzeichnend ist, dass der Leistungshalbleiterschalter (T) eingeschaltet ist, wobei der zweite Schwellenwert (Th2) in Abhängigkeit von der Durchlassspannung (U_{CE}) an dem Leistungshalbleiterschalter (T) im leitenden Zustand gewählt ist und im Bereich von 10 Volt bis 0,5 Volt liegt; und/oder
dass erfasst wird, dass der zwischen dem ersten und dem zweiten Anschluss (C, E) fließende Strom (I_{C}) eine Stromspitze (48), die der Rückstromspitze einer zu dem Leistungshalbleiterschalter gehörenden kommutierenden Diode entspricht, durchlaufen hat und nach Durchlaufen der Rückstromspitze einen ersten Schwellenwert (Th1) unterschritten hat, bei dem die Änderungsgeschwindigkeit (dI_{c}/dt) des Stroms durch den Leistungshalbleiterschalter (T) betragsmäßig weniger als 20 % des Stromanstiegs von 10 % bis 90 % des Stroms (I_{c}) beim Einschalten des Leistungshalbleiterschalters (T) beträgt.

2. Verfahren nach Anspruch 1, **dadurch gekennzeichnet, dass** das Anlegen der ersten Ansteuerspannung als Reaktion auf den Empfang eines Steuersignals (S) von einer übergeordneten Steuereinrichtung (27) erfolgt.

3. Verfahren nach Anspruch 1 oder 2, **dadurch gekennzeichnet, dass** das Erfassen von Bedingungen, die den Fortgang eines Einschaltvorgangs des Leistungshalbleiterschalters (T) kennzeichnen, ein Erfassen der Zeitdauer seit dem Anlegen der ersten Ansteuerspannung an den Steueranschluss (G) aufweist.

4. Verfahren nach einem beliebigen der vorhergehenden Ansprüche, **dadurch gekennzeichnet, dass** das Erfassen von Bedingungen, die dafür kennzeichnend sind, dass der Einschaltvorgang als abgeschlossen gilt, aufweist, dass der Ablauf einer Zeitdauer tₜₕ = t_{d(on)} + tᵣ + t_{add} seit dem Zeitpunkt des Anlegens der ersten Ansteuerspannung erfasst wird, wobei t_{d(on)} die Einschaltverzögerung und tᵣ die Anstiegszeit des Stromes des Leistungshalbleiterschalters sind, wie sie für den Leistungshalbleiterschaltertyp spezifiziert sind, und t_{add} eine zusätzliche Zeit ist, die vorzugsweise im Bereich zwischen 0 und 20 µs liegt, mehr bevorzugt zwischen 5 und 15 µs beträgt.

5. Verfahren nach einem beliebigen der vorhergehenden Ansprüche, **dadurch gekennzeichnet, dass** der zweite Schwellenwert (Th2) kleiner als 5 Volt ist.

6. Verfahren nach einem beliebigen der vorhergehenden Ansprüche, **dadurch gekennzeichnet, dass** der erste Schwellenwert (Th1) derart gewählt ist, dass bei ihm die Änderungsgeschwindigkeit (dI_{c}/dt) des Stroms durch den Leistungshalbleiterschalter (T) betragsmäßig weniger als 10 % des Stromanstiegs von 10 % bis 90 % des Stroms (I_{c}) beim Einschalten des Leistungshalbleiterschalters (T) beträgt.

7. Verfahren nach einem beliebigen der vorhergehenden Ansprüche, **dadurch gekennzeichnet, dass** der Leistungshalbleiterschalter (T) ein IGBT oder ein MOSFET ist, die erste Ansteuerspannung 10-15 Volt beträgt und die zweite Ansteuerspannung 15-20 Volt oder mehr beträgt.

8. Verfahren nach Anspruch 7, **dadurch gekennzeichnet, dass** die zweite Ansteuerspannung höher ist als der für den Dauerbetrieb des Leistungshalbleiterschalters (T) spezifizierte Parameter.

9. Vorrichtung zur Ansteuerung eines spannungsgesteuerten wiederabschaltbaren Leistungshalbleiterschalters (T), der einen ersten und einen zweiten Anschluss (C, E) sowie einen Steueranschluss (G) aufweist, insbesondere eines IGBTs oder eines MOSFETs, wobei der Leistungshalbleiterschalter (T) im eingeschalteten Zustand zwischen dem ersten und dem zweiten Anschluss (C, E) leitend ist, wobei die Vorrichtung zur Durchführung des Verfahrens nach einem beliebigen der vorhergehenden Ansprüche eingerichtet ist und wobei die Vorrichtung (26) aufweist:
eine Erfassungseinrichtung (34, 36) zur Erfassung wenigstens eines Betriebsparameters an dem Leistungshalbleiterschalter (T), wozu wenigstens ein Spannungspotential an einem der Anschlüsse (C, G, E) des Leistungshalbleiterschalters (T) und/oder der Laststrom (I_{c}) durch den Leistungshalbleiterschalter (T) gehören; und
eine Regeleinrichtung (51, 51`) zur Regelung der an die Steuerelektrode (G) des Leistungshalbleiterschalters (T) angelegten Spannung auf den zweiten Wert der zweiten Ansteuerspannung in einer geschlossenen Regelschleife unter Verwendung der gemessenen Durchlassspannung (U_{CE}) und/oder des gemessenen Laststroms (I_{c}) des Leistungshalbleiterschalters (T) als die zur Rückführung für die Regelschleife dienende Messgröße.

10. Vorrichtung nach Anspruch 9, **dadurch gekennzeichnet, dass** sie eine Treibereinrichtung (38) aufweist, die eingerichtet ist, um EIN- und AUS-Steuerbefehle zu empfangen und Ansteuerspannungen für den Leistungshalbleiterschalter (T) zu erzeugen, wobei die Vorrichtung (26) ferner eine Zeitkontrolleinrichtung (33) zur Erfassung der Zeitdauer seit dem Anlegen der ersten Ansteuerspannung an den Steueranschluss (G) aufweist.

11. Stromrichter zur Umwandlung von Gleichstrom in Wechselstrom oder umgekehrt mit einer Vielzahl von Leistungshalbleiterschaltern (T), wobei den Leistungshalbleiterschaltern (T) jeweils einzeln oder gruppenweise eine Vorrichtung (26) nach einem der Ansprüche 9 bis 10 zugeordnet ist.

12. Stromrichter nach Anspruch 11, der ferner eine Steuereinrichtung (27) zur Steuerung des Betriebs des Stromrichters (8) auf der Basis der momentanen Betriebsbedingungen aufweist, wobei die Steuereinrichtung (27) eingerichtet ist, um Steuer- und Schaltsignale (S) für die Vorrichtungen (26; 26_1, 26_2) in Abhängigkeit von aktuellen Betriebsbedingungen und Parametern zu bestimmen, die von einer Überwachungseinrichtung im laufenden Betrieb gemessen oder ermittelt werden,
wobei die Vorrichtungen (26; 26_1, 26_2) in Abhängigkeit von den von der Steuereinrichtung (27) empfangenen Steuersignalen (S) Ansteuersignale (S`, S`1, S`2) für die zugehörigen Leistungshalbleiterschalter (T) erzeugen und die zugehörigen Leistungshalbleiterschalter (T) auf der Basis der Steuersignale (S) ansteuern.

13. Datenträger, der computerlesbare Anweisungen zum Ausführen des Verfahrens nach einem der Ansprüche 1 bis 8 aufweist.

## Claims

1. A method of driving a voltage-controlled turn-off power semiconductor switch (T), which has a first and a second terminal (C, E) and a control terminal (G), in particular an IGBT or a MOSFET, wherein the power semiconductor switch (T) is conductive between the first and the second terminal (C, E) in the turned-on state, the method comprising:
applying a first drive voltage, which has a first value, to the control terminal (G) to turn on the power semiconductor switch (T) (S2),
detecting conditions which characterize the progress of a turn on process of the power semiconductor switch (T) (S3) by detecting at least one operating parameter on the power semiconductor switch (T), including at least one voltage potential at one of the terminals (C, G, E) of the power semiconductor switch (T) and/or the load current (I_{c}) through the power semiconductor switch (T),
detecting conditions indicative of the turn on process being deemed to be completed (S4), and
applying a second drive voltage, which has a second value that is higher than the first value, to the control terminal (G) in order to operate the power semiconductor switch (T) in the conductive state (S5) as soon as conditions are detected, which are indicative of the turn on process being deemed to be completed (S5),
wherein the second drive voltage applied to the control terminal (G) of the power semiconductor switch (T) is controlled to the second value in a closed control loop (51, 51'), wherein the measured forward voltage (U_{CE}) and/or the measured load current (I_{c}) of the power semiconductor switch (T) forms the measured variable used for feedback for the control loop, and
wherein detecting conditions indicative of the turn on process being deemed to be completed (S4) includes the fact that at least one of the following criteria is met:
it is detected that the voltage (U_{GE}) at the control terminal (G) reaches or exceeds a third threshold value (Th3), which is higher than a value of a Miller plateau (47) of the drive voltage and is at least 90% of the value of the first drive voltage;
it is detected that the forward voltage between the first and the second terminal (C, E) reaches or falls below a second threshold value (Th2), which is indicative of the fact that the power semiconductor switch (T) is turned on, wherein the second threshold value (Th2) is selected as a function of the forward voltage (U_{CE}) at the power semiconductor switch (T) in the conductive state and is in the range from 10 volts to 0.5 volts; and/or
it is detected that the current (I_{C}) flowing between the first and the second terminal (C, E) has passed through a current peak (48), which corresponds to the reverse current peak of a commutating diode associated to the power semiconductor switch, and after passing through the reverse current peak has fallen below a first threshold value (Th1), at which the absolute value of the rate of change (dI_{c}/dt) of the current through the power semiconductor switch (T) is less than 20% of the current rise from 10% to 90% of the current (I_{C}) when turning on the power semiconductor switch (T).

2. The method according to claim 1, **characterized in that** the application of the first drive voltage is effected in response to the receipt of a control signal (S) from a higher-level control device (27).

3. The method according to claim 1 or 2, **characterized in that** detecting conditions which characterize the progress of a turn on process of the power semiconductor switch (T) includes detecting the period of time since the first drive voltage was applied to the control terminal (G).

4. The method according to anyone of the preceding claims, **characterized in that** detecting conditions indicative of the turn on process being deemed to be completed comprises detecting the elapse of a period of time tₜₕ = t_{d(on)} + tᵣ + t_{add} since the time of application of the first drive voltage, where t_{d(on)} is the turn-on delay and tᵣ is the rise time of the current of the power semiconductor switch as specified for the power semiconductor switch type, and t_{add} is an additional time, which is preferably in the range between 0 and 20 µs, more preferably between 5 and 15 µs.

5. The method according to anyone of the preceding claims, **characterized in that** the second threshold value (Th2) is less than 5 volts.

6. The method according to anyone of the preceding claims, **characterized in that** the first threshold value (Th1) is selected such that at the first threshold value the absolute value of rate of change (dI_{c}/dt) of the current through the power semiconductor switch (T) is less than 10 % of the current rise from 10% to 90% of the current (I_{c}) when turning on the power semiconductor switch (T).

7. The method according to anyone of the preceding claims, **characterized in that** the power semiconductor switch (T) is an IGBT or a MOSFET, the first drive voltage is 10-15 volts, and the second drive voltage is 15-20 volts or more.

8. The method according to claim 7, **characterized in that** the second drive voltage is higher than the parameter specified for continuous operation of the power semiconductor switch (T).

9. A device for driving a voltage-controlled turn-off power semiconductor switch (T), which has a first and a second terminal (C, E) and a control terminal (G), in particular an IGBT or a MOSFET, wherein the power semiconductor switch (T) is conductive between the first and the second terminal (C, E) in the turned-on state, wherein the device is arranged for carrying out the method according to anyone of the preceding claims and wherein the device (26) comprises:
a detection device (34, 36) for detecting at least one operating parameter on the power semiconductor switch (T), including at least one voltage potential on one of the terminals (C, G, E) of the power semiconductor switch (T) and/or the load current (I_{c}) through the power semiconductor switch (T); and
a control device (51, 51') for controlling the voltage applied to the control electrode (G) of the power semiconductor switch (T) to the second value of the second drive voltage in a closed control loop using the measured forward voltage (U_{CE}) and/or the measured load current (I_{c}) of the power semiconductor switch (T) as the measured variable serving for feedback for the control loop.

10. The device according to claim 9, **characterized in that** it comprises a driver device (38) configured to receive ON and OFF control commands and to generate drive voltages for the power semiconductor switch (T), wherein the device (26) also comprises a time control device (33) for detecting the period of time since the first drive voltage was applied to the control terminal (G).

11. A power converter for converting direct current into alternating current or vice versa having a plurality of power semiconductor switches (T), wherein a device (26) according to anyone of the claims 9 to 10 is assigned to the power semiconductor switches (T) individually or in groups.

12. The power converter according to claim 11, further comprising a control device (27) for controlling the operation of the power converter (8) based on the current operating conditions, wherein the control device (27) is configured to determine control and switching signals (S) for the devices (26; 26_1, 26_2) depending on current operating conditions and parameters that are measured by a monitoring device during operation,
wherein the devices (26; 26_1, 26_2) generate control signals (S', S'1, S'2) for the associated power semiconductor switches (T) as a function of the control signals (S) received from the control device (27) and drive the associated power semiconductor switches (T) based on the control signals (S).

13. A data carrier comprising computer-readable instructions for carrying out the method according to anyone of claims 1 to 8.

## Revendications

1. Procédé pour la commande d'un commutateur à semi-conducteurs de puissance (T) à nouveau commutable commandé par tension, qui présente une première et une seconde borne (C, E) ainsi qu'une borne de commande (G), en particulier d'un IGBT ou d'un MOSFET, dans lequel le commutateur à semi-conducteurs de puissance (T) est conducteur à l'état de marche entre la première et la seconde borne (C, E), dans lequel le procédé présente :
la création d'une première tension de commande qui présente une première valeur, au niveau de la borne de commande (G), pour mettre en marche (S2) le commutateur à semi-conducteurs de puissance (T), et
la détection de conditions qui reconnaissent (S3) la progression d'un processus de mise en marche du commutateur à semi-conducteurs de puissance (T) par la détection d'au moins un paramètre opérationnel au niveau du commutateur à semi-conducteurs de puissance (T), auquel appartiennent au moins un potentiel de tension au niveau d'une des bornes (C, G, E) du commutateur à semi-conducteurs de puissance (T) et/ou le courant de charge (I_{c}) à travers le commutateur à semi-conducteurs de puissance (T),
la détection de conditions qui sont reconnaissables en ce que le processus de mise en marche est considéré comme terminé (S4), et
la création d'une deuxième tension de commande qui présente une deuxième valeur qui est plus élevée que la première valeur, au niveau de la borne de commande (G), pour exploiter le commutateur à semi-conducteurs de puissance (T) à l'état conducteur, dès que des conditions sont détectées qui sont reconnaissables en ce que le processus de mise en marche est considéré comme terminé (S4),
dans lequel la deuxième tension de commande créée au niveau de la borne de commande (G) du commutateur à semi-conducteurs de puissance (T) est réglée sur la deuxième valeur dans une boucle d'asservissement fermée (51, 51'), dans lequel la tension à l'état passant mesurée (U_{CE}) et/ou le courant de charge mesuré (I_{c}) du commutateur à semi-conducteurs de puissance (T) forment la grandeur de mesure servant à la restitution pour la boucle d'asservissement, et
dans lequel la détection de conditions qui sont reconnaissables en ce que le processus de mise en marche est considéré (S4) comme terminé présente le fait qu'au moins un des critères suivants est rempli :
en ce qu'il est détecté que la tension (U_{GE}) au niveau de la borne de commande (G) atteint ou dépasse une troisième valeur de seuil (Th3) qui est supérieure à une valeur d'un plateau Miller (47) de la tension de commande et représente au moins 90 % de la valeur de la première tension de commande ;
en ce qu'il est détecté que la tension à l'état passant entre la première et la deuxième borne (C, E) atteint ou devient inférieure à une deuxième tension de seuil (Th2) qui est reconnaissable en ce que le commutateur à semi-conducteurs de puissance (T) est en marche, dans lequel la deuxième valeur de seuil (Th2) est choisie à l'état conducteur en fonction de la tension à l'état passant (U_{CE}) au niveau du commutateur à semi-conducteurs de puissance (T) et se trouve dans la plage de 10 volts à 0,5 volt ; et/ou
en ce qu'il est détecté que le courant (I_{c}) circulant entre la première et la deuxième borne (C, E) a passé une pointe de courant (48) qui correspond à la pointe de courant de refoulement d'une diode de commutation appartenant au commutateur à semi-conducteurs de puissance et après le passage de la pointe de courant de refoulement est devenu inférieur à une première valeur de seuil (Th1), dans laquelle la vitesse de modification (dl_{c}/dt) du courant représente à travers le commutateur à semi-conducteurs de puissance (T) en amplitude moins de 20 % de l'augmentation de courant de 10 % à 90 % du courant (I_{c}) lors de la mise en marche du commutateur à semi-conducteurs de puissance (T).

2. Procédé selon la revendication 1, **caractérisé en ce que** la création de la première tension de commande a lieu en réaction à la réception d'un signal de commande (S) par un dispositif de commande supérieur (27).

3. Procédé selon la revendication 1 ou 2, **caractérisé en ce que** la détection de conditions qui reconnaissent la progression d'un processus de mise en marche du commutateur à semi-conducteurs de puissance (T) présente une détection de la durée depuis la création de la première tension de commande au niveau de la borne de commande (G).

4. Procédé selon l'une quelconque des revendications précédentes, **caractérisé en ce que** la détection de conditions qui sont reconnaissables **en ce que** le processus de mise en marche est considéré comme terminé présente le fait que le déroulement d'une durée tₜₕ = t_{d(on)} + tᵣ + tadd depuis le moment de la création de la première tension de commande est détecté, dans lequel t_{d(on)} est la temporisation de mise en marche et tᵣ est le temps de montée du courant du commutateur à semi-conducteurs de puissance, comme ils sont précisés pour le type de commutateur à semi-conducteurs de puissance, et t_{add}est un temps supplémentaire qui se situe de préférence dans la plage entre 0 et 20 µs, plus préférablement entre 5 et 15 µs.

5. Procédé selon l'une quelconque des revendications précédentes, **caractérisé en ce que** la deuxième valeur de seuil (Th2) est inférieure à 5 volts.

6. Procédé selon l'une quelconque des revendications précédentes, **caractérisé en ce que** la première valeur de seuil (Th1) est choisie de telle sorte que, avec celle-ci, la vitesse de modification (dl_{c}/dt) du courant à travers le commutateur à semi-conducteurs de puissance (T) représente en amplitude moins de 10 % de l'augmentation de courant de 10 % à 90 % du courant (I_{c}) lors de la mise en marche du commutateur à semi-conducteurs de puissance (T).

7. Procédé selon l'une quelconque des revendications précédentes, **caractérisé en ce que** le commutateur à semi-conducteurs de puissance (T) est un IGBT ou un MOSFET, la première tension de commande représente 10 à 15 volts et la deuxième tension de commande représente 15 à 20 volts ou plus.

8. Procédé selon la revendication 7, **caractérisé en ce que** la deuxième tension de commande est supérieure au paramètre précisé pour l'exploitation continue du commutateur à semi-conducteurs de puissance (T).

9. Dispositif pour la commande d'un commutateur à semi-conducteurs de puissance (T) à nouveau commutable commandé par tension qui présente une première et une seconde borne (C, E) ainsi qu'une borne de commande (G), en particulier d'un IGBT ou d'un MOSFET, dans lequel le commutateur à semi-conducteurs de puissance (T) est conducteur à l'état en marche entre la première et la seconde borne (C, E), dans lequel le dispositif est conçu pour la réalisation du procédé selon l'une quelconque des revendications précédentes et dans lequel le dispositif (26) présente :
un dispositif de détection (34, 36) pour la détection d'au moins un paramètre opérationnel au niveau du commutateur à semi-conducteurs de puissance (T), auquel appartiennent au moins un potentiel de tension au niveau d'une des bornes (C, G, E) du commutateur à semi-conducteurs de puissance (T) et/ou le courant de charge (I_{c}) à travers le commutateur à semi-conducteurs de puissance (T) ; et
un dispositif de régulation (51, 51') pour la régulation de la tension créée au niveau de l'électrode de commande (G) du commutateur à semi-conducteurs de puissance (T) sur la deuxième valeur de la seconde tension de commande dans une boucle d'asservissement fermée en utilisant la tension à l'état passant mesurée (U_{CE}) et/ou le courant de charge mesuré (I_{c}) du commutateur à semi-conducteurs de puissance (T) en tant que grandeur de mesure servant à la restitution pour la boucle d'asservissement.

10. Dispositif selon la revendication 9, **caractérisé en ce qu'**il présente un système d'entraînement (38) qui est conçu pour recevoir des instructions de commande de Mise en marche et d'Extinction et générer des tensions de commande pour le commutateur à semi-conducteurs de puissance (T), dans lequel le dispositif (26) présente en outre un système de commande temporelle (33) pour la détection de la durée depuis la création de la première tension de commande au niveau de la borne de commande (G).

11. Convertisseur de courant pour la transformation de courant continu en courant alternatif ou inversement avec une pluralité de commutateurs à semi-conducteurs de puissance (T), dans lequel respectivement de manière isolée ou groupée un dispositif (26) selon l'une des revendications 9 à 10 est associé aux commutateurs à semi-conducteurs de puissance (T).

12. Convertisseur de courant selon la revendication 11, qui présente en outre un système de commande (27) pour la commande de l'exploitation du convertisseur de courant (8) sur la base des conditions d'exploitation momentanées, dans lequel le système de commande (27) est conçu pour déterminer des signaux de commande et de commutation (S) pour les dispositifs (26 ; 26_1, 26_2) en fonction de conditions d'exploitation et de paramètres actuels qui sont mesurés ou déterminés pendant l'exploitation par un système de surveillance,
dans lequel les dispositifs (26 ; 26_1, 26_2) génèrent en fonction des signaux de commande (S) reçus par le système de commande (27) des signaux de commande (S', S'1, S'2) pour les commutateurs à semi-conducteurs de puissance (T) correspondants et qui commandent les commutateurs à semi-conducteurs de puissance (T) correspondants sur la base des signaux de commande (S).

13. Support de données qui présente des instructions lisibles par ordinateur pour la réalisation du procédé selon l'une quelconque des revendications 1 à 8.
